(19) Europäisches Patentamt
European Patent Office
Office européen des brevets

(11) **EP 2 260 125 B1**

(12) **EUROPÄISCHE PATENTSCHRIFT**

(45) Veröffentlichungstag und Bekanntmachung des Hinweises auf die Patenterteilung:
**09.02.2022 Patentblatt 2022/06**

(21) Anmeldenummer: **09722727.6**

(22) Anmeldetag: **12.03.2009**

(51) Internationale Patentklassifikation (IPC):
*C25D 1/08* (2006.01)   *C25D 5/18* (2006.01)
*B01J 19/00* (2006.01)   *B01J 23/42* (2006.01)
*B01J 23/72* (2006.01)   *B22F 1/00* (2022.01)
*B22F 3/00* (2021.01)   *B81C 99/00* (2010.01)
*B82Y 15/00* (2011.01)   *B82Y 30/00* (2011.01)
*C25D 1/00* (2006.01)   *B01J 35/00* (2006.01)

(52) Gemeinsame Patentklassifikation (CPC):
**C25D 1/006; B01J 19/0093; B01J 23/42;**
**B01J 23/72; B01J 35/0006; B22F 1/0547;**
**B22F 3/002; B81C 99/0085; B82Y 15/00;**
**B82Y 30/00; C25D 1/08; C25D 5/18; C25D 5/617;**
B01J 2219/00783; B01J 2219/00835;   (Forts.)

(86) Internationale Anmeldenummer:
**PCT/EP2009/001776**

(87) Internationale Veröffentlichungsnummer:
**WO 2009/115227 (24.09.2009 Gazette 2009/39)**

(54) **NANODRAHT-STRUKTURELEMENT**

NANOWIRE STRUCTURAL ELEMENT

ÉLÉMENT STRUCTUREL À NANOFILS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **20.03.2008 DE 102008015333**

(43) Veröffentlichungstag der Anmeldung:
**15.12.2010 Patentblatt 2010/50**

(73) Patentinhaber: **GSI Helmholtzzentrum für Schwerionenforschung GmbH 64291 Darmstadt (DE)**

(72) Erfinder:
• CORNELIUS, Thomas
38000 Grenoble (FR)
• ENSINGER, Wolfgang
64839 Münster (DE)
• NEUMANN, Reinhard
69221 Dossenheim (DE)
• RAUBER, Markus
64289 Darmstadt (DE)

(74) Vertreter: **Mergel, Volker et al Blumbach - Zinngrebe Patent- und Rechtsanwälte PartG mbB Alexandrastraße 5 65187 Wiesbaden (DE)**

(56) Entgegenhaltungen:
US-A- 5 449 917       US-A- 6 033 583
US-A1- 2005 230 353    US-B1- 6 328 342

• WANG, D ET AL: "AGeneral Route to Macroscopic Hierarchical 3DNanowire Networks" ANGEWANDTE CHEMIE INTERNATIONAL EDITION, Bd. 43, Nr. 45, 17. November 2004 (2004-11-17), Seiten 6169-6173, XP002547982
• GU, Z. ET AL: "Three-Dimensional Electrically Interconnected Nanowire Networks Formed by Diffusion Bonding" LANGMUIR, Bd. 23, Nr. 3, 23. Dezember 2006 (2006-12-23), Seiten 979-982, XP002547983

- LINDEBERG M; HJORT K: "Interconnected nanowire clusters in polyimide for flexible circuits and magnetic sensing applications" SENSORS AND ACTUATORS A, ELSEVIER SEQUOIA S.A., LAUSANNE, CH, Bd. 105, Nr. 2, 15. Juli 2003 (2003-07-15) , Seiten 150-161, XP004428584 ISSN: 0924-4247
- LIU J; DUAN J L; TOIMIL-MOLARES M E; KARIM S; CORNELIUS T W; DOBREV D; YAO H J; SUN Y M; HOU M D; MO D; WANG Z G; NEUMANN R: "Electrochemical fabrication of single-crystalline and polycrystalline Au nanowires: the influence of deposition parameters; Electrochemical fabrication of single-crystalline and polycrystalline Au nanowires: the influence of deposition parameters" NANOTECHNOLOGY, IOP, BRISTOL, GB, Bd. 17, Nr. 8, 28. April 2006 (2006-04-28) , Seiten 1922-1926, XP020104660 ISSN: 0957-4484
- Rauber, M.: "Herstellung und Charakterisierung von Edelmetall-Nanodraht-Arrays - Diplomarbeit" 31. August 2007 (2007-08-31), Philipps-Universität Marburg - GSI Helmholtzzentrum für Schwerionenforschung GmbH , XP002547634 Seite 8, Zeile 1 - Seite 13, Zeile 26 Seite 14, Zeile 1 - Seite 18, Zeile 4 Seite 26, Zeile 3 - Seite 28, Zeile 10 Seite 45, Zeile 9 - Seite 50, Zeile 2 Seite 61, Zeilen 3-10 Abbildungen 2.2, 2.11, 2.12, 4.15-4.26
- MUKHERJI D; PIGOZZI G; SCHMITZ F; NÄTH O; RÖSLER J; KOSTORZ G: "Nano-structured materials produced from simple metallic alloys by phase separation; Nano-structured materials produced from simple metallic alloys by phase separation" NANOTECHNOLOGY, IOP, BRISTOL, GB, Bd. 16, Nr. 10, 1. Oktober 2005 (2005-10-01), Seiten 2176-2187, XP020090762 ISSN: 0957-4484

(52) Gemeinsame Patentklassifikation (CPC): (Forts.)
B01J 2219/00846; B01J 2219/00853;
B01J 2219/0086; B01J 2219/00873;
B81B 2201/0292; B81B 2201/051

## Beschreibung

Gebiet der Erfindung

Die Erfindung betrifft ein Nanodraht-Strukturelement, ein Verfahren zu dessen Herstellung und ein Mikroreaktorsystem, insbesondere ein Mikrokatalysatorsystem.

Hintergrund der Erfindung

K. Jähnisch et al. haben in "Chemistry in Microstructured Reactors", Ang. Chem. Int. Ed. 2004, 43, 406-446 die Vorteile mikrostrukturierter Bauelemente für chemische Reaktionen und analytische Zwecke demonstriert. Dies führte zu einem Gewinn an Bedeutung solcher Systeme für die chemische Synthese und Analyse. Im Vergleich zu konventionellen Reaktoren besitzen diese Mikrostrukturreaktoren ein sehr großes Oberflächen-Volumen-Verhältnis, was die Wärmeaustauschleistung sowie den Ablauf des Stofftransportes positiv beeinflusst (vgl. O. Wörz et al. "Microreactors - a New Efficient Tool for Reactor Development", Chem. Eng. Technol. 2001, 24, 138-142).

Es wurden bereits viele bekannte Reaktionen in Mikrostrukturreaktoren durchgeführt, unter anderem auch viele katalytische Reaktionen. Hierbei ist es gleichgültig, ob es sich um Flüssigphasen-, Gasphasen- oder Gas-Flüssigphasen-Reaktionen handelt. Um die potentielle Aktivität des Katalysators nutzen zu können, wird das Katalysatormaterial in mikrostrukturierte Systeme mit verschiedenen geometrischen Formen integriert. Geht man vom einfachsten Fall aus, so besteht das Reaktormaterial, welches zum Bau des Mikroreaktors verwendet wird, selbst aus der katalytisch aktiven Substanz (vgl. M. Fichtner, "Microstructured Rhodium Catalysts for the Partial Oxidation of Methane to Syngas under Pressure", Ind. Eng. Chem. Res. 2001, 40, 3475-3483). Das hat jedoch zur Folge, dass die Katalysatoroberfläche auf die Reaktorwand beschränkt ist. Dieser Nachteil wird teilweise mit Hilfe optimierter Katalysator/Träger-Systeme umgangen. Meist beinhalten die heutigen Mikrostrukturreaktoren kleine Partikel oder Pulver, die in einen Kanal eingetragen wurden.

Es kommen aber auch Katalysator-Filamente, Drähte und Membranen zum Einsatz (vgl. G. Veser, "Experimental and Theoretical Investigation of H2 Oxidation in a High-Temperature Catalytic Microreactor", Chem. Eng. Sci. 2001, 56, 1265-1273). Metallische Nanostrukturen, insbesondere solche aus Edelmetallen, sind aufgrund ihres großen Verhältnisses von Oberfläche zu Masse, was mit geringeren Herstellungskosten verbunden ist, in der heterogenen Katalyse bekannt (vgl. R. Narayanan et al. "Catalysis with Transition Metal Nanoparticles in Colloidal Solution: Nanoparticle Shape Dependence and Stability" J. Chem. Phys. B, 2005, 109, 12663-12676).

Ursprünglich konzentrierte sich die Forschung in den Nanowissenschaften auf die Untersuchung isotroper Metallpartikel, weswegen ihre katalytischen Eigenschaften gut erforscht sind. Bis heute wurden aber auch viele eindimensionale Nanostrukturen in Hinblick auf ihren Einsatz in der heterogenen Katalyse analysiert. Ein großes Problem stellt jedoch deren Immobilisierung dar. Aus Z. Chen et al., "Supportless Pt and PtPd Nanotubes as Electrocatalysts for Oxygen-Reduction Reactions", Angew. Chem. 2007, 119, S. 4138-4141, ist bekannt, Nanostrukturen auf einen Träger aufzubringen oder in poröse Materialien wie z. B. Nafion einzulagern, was jedoch zwangsläufig zu einer Abnahme der nutzbaren Katalysatoroberfläche führt. Zudem muss beachtet werden, dass die katalytische Aktivität aufgrund von Diffusionsprozessen von der Verteilung des Katalysatormaterials abhängt. Demnach erhöhen die Nanopartikel das Oberflächen-Volumen-Verhältnis zwar drastisch, jedoch fällt die Langzeitstabilität solcher Reaktoren aus folgenden Gründen relativ gering aus:

1. Verlust des Kontaktes von Nanopartikeln aufgrund von Korrosion des Trägers,
2. Auflösung und erneute Abscheidung oder Ostwald-Reifung,
3. Aggregation der Nanopartikel, um die Oberflächenenergie zu minimieren und
4. Auflösung der Nanopartikel und Migration der löslichen Ionen.

Parallel ausgerichtete Draht- und Röhrenanordnungen wurden bereits als Glucose-Sensor (J. H. Yuan, et al., "Highly ordered Platinum-Nanotubule Arrays for Amperometric Glucose Sensing", Adv. Funct. Mater 2005, 15, 803), als Elektrokatalysator z. B. in der Alkoholoxidation (H. Wang et al., "Pd nanowire arrays as electrocatalysts for ethanol electrooxidation", Electrochem. Commun. 2007, 9, 1212-1216) und der Wasserstoffperoxidreduktion (H. M. Zhang et al., "novel .electrocatalytic activity in layered Ni-Cu nanowire arrays", Chem. Commun. 2003, 3022) eingesetzt. In diesen Fällen sind die Nanostrukturen jedoch nicht sonderlich stabil.

Nielsch et al. berichten in "Uniform Nickel Deposition into ordered Alumina pores by pulsed electrodeposition", Adv. Mater. 2000, 12, 582-586, dass gepulste Abscheidung zur Abscheidung von dünnen, metallischen Filmen genutzt wird.

Ein Verfahren zur Nanodrahterzeugung ist z.B. aus T. W. Cornelius et al., "Controlled fabrication of poly- and single-crystalline bismuth nanowires", Nanotechnology 2005, 16, S. 246-249; oder aus den Dissertationen von Thomas Walter Cornelius, GSI, 2006; Florian Maurer, GSI, 2007, sowie Shafqat Karim, GSI, 2007 bekannt, welche hiermit durch Referenz inkorporiert werden. Bei diesen Verfahren wurden allerdings lediglich einzelne Nanodrähte gewonnen.

Lindberg et al. offenbaren in "Interconnected nanowire clusters in polyimide for flexible circuits and magnetic sensing applications", Sensors and Actuators A, 2003, 105, 150-161, ein Verfahren zur Herstellung eines Nanodraht-Strukturelements.

Allgemeine Beschreibung der Erfindung

Die Erfindung hat sich die Aufgabe gestellt, ein komplexes Nanodraht-Strukturelement und ein Verfahren zu dessen Herstellung bereit zu stellen, welches eine stabile Hohlraumstruktur mit großer spezifischer Oberfläche aufweist.

Eine weitere Aufgabe der Erfindung ist es, ein derartiges Nanodraht-Strukturelement bereit zu stellen, welches vielseitig anwendbar ist und sich z.B. als Katalysatorelement eignet.

Die Aufgabe der Erfindung wird durch den Gegenstand der unabhängigen Ansprüche gelöst. Vorteilhafte Weiterbildungen der Erfindung sind in den Unteransprüchen definiert.

Es wird ein Verfahren zur Herstellung eines Nanodraht-Strukturelements bereit gestellt, welches ein Nanodraht-Array aus einer Vielzahl von Nanodrähten umfasst, wobei die Nanodrähte in unterschiedlichen Richtungen verlaufen und sich die in unterschiedlichen Richtungen verlaufenden Nanodrähte kreuzen und somit ein vermaschtes Netzwerk aus den Nanodrähten bilden. Das vermaschte Netzwerk bildet dabei einen offenzelligen Hohlraum mit sehr großer Wechselwirkungsoberfläche.

Das Ergebnis des Herstellungsverfahrens ist ein Nanodraht-Strukturelement umfassend ein Array aus einer Vielzahl von Nanodrähten, wobei die Nanodrähte einen Durchmesser von kleiner oder gleich 2000 nm aufweisen, wobei die Nanodrähte in unterschiedlichen Richtungen verlaufen und sich die Nanodrähte an einer Vielzahl von Knotenpunkten kreuzen, wobei die Nanodrähte an den Knotenpunkten miteinander verwachsen sind, so dass die Nanodrähte zu einem Netzwerk vernetzt sind, wobei die Nanodrähte in dem Netzwerk entlang zumindest drei vordefinierten unterschiedlichen Richtungen verlaufen, und wobei die drei unterschiedlichen Richtungen nicht in einer gemeinsamen Ebene liegen und- die Nanodrähte dreidimensional vernetzt sind.

Zur Herstellung wird ein sogenanntes templatbasiertes Verfahren wie folgt angewendet.

In einem ersten Verfahrensschritt (a) wird zunächst ein dielektrisches Templat, insbesondere eine dielektrische Templatfolie bereitgestellt. Die Templatfolie ist z.B. eine gewöhnliche handelsübliche Kunststofffolie, insbesondere eine Polymerfolie.

In einem nachfolgenden Verfahrensschritt (b) wird die Templatfolie mit energetischer Strahlung unter zumindest drei oder mehr, unterschiedlichen Winkeln bezogen auf die Oberfläche des Templats, das heißt aus zumindest drei, oder mehr, unterschiedlichen Richtungen insbesondere mit einem hochenergetischen Ionenstrahl, wie er z.B. an den Beschleunigeranlagen der Gesellschaft für Schwerionenforschung mbH in Darmstadt verfügbar ist, bestrahlt. Durch die Bestrahlung entsteht eine Vielzahl von Spuren, die die Templatfolie durchsetzen. Die Spuren sind dadurch gekennzeichnet, dass die Molekularstruktur, z.B. die Polymerstruktur der Folie entlang der Trajektorie jedes einzelnen Bestrahlungsions zerstört wird. Diese Spuren werden als "latente Spuren" bezeichnet. Der Schaden ist in dem Spurkern am größten und nimmt mit $1/r^2$ ab. Durch Ätztechniken kann das Material mit zerstörter Molekularstruktur aus der Spur entfernt werden und die latente Spur so zu einem offenen Kanal bzw. einer sogenannten Nanopore aufgeätzt werden. Die latenten Spuren und damit die nachfolgend erzeugten Nanoporen sind hierbei stochastisch in Bezug auf die Ebene der Templatoberfläche verteilt.

Erfindungsgemäß wird das Templat bzw. die Templatfolie in dem Schritt (b) unter zumindest drei, oder mehr Winkeln zur Oberfläche des Templats - mit anderen Worten aus zumindest drei oder mehr unterschiedlichen Richtungen - mit dem Ionenstrahl bestrahlt. Somit entstehen zunächst latente Spuren in der Templatfolie, die zumindest in drei, oder mehr unterschiedlichen nicht parallelen Richtungen verlaufen. Z.B. wird eine Polycarbonatfolie mit schweren Ionen mit einer Energie von einigen bis einigen zehn MeV/u unter zwei Winkeln (+45°,-45°) bezogen auf die Flächennormale der Templatfolie bestrahlt.

Erfindungsgemäß wird die Templatfolie dabei aus zumindest drei (oder mehr) unterschiedlichen Richtungen bestrahlt, die nicht in einer gemeinsamen Ebene liegen, wodurch ein dreidimensional vernetztes Nanoporen-Netzwerk hergestellt werden kann, wie nachfolgend noch genauer erläutert wird. Z.B. wird eine Polycarbonatfolie mit schweren Ionen mit einer Energie von einigen bis einigen hundert MeV/u aus drei unterschiedlichen Richtungen, z.B. mit einem Polarwinkel von jeweils 45° zur Flächennormalen und mit Azimutalwinkeln von 0°, 120° und 240° um die Flächennormale mit einer Fluenz von jeweils einigen $10^8$ Ionen/cm$^{-2}$ bestrahlt. Es ist ersichtlich, dass die Komplexität des Netzwerks durch weitere Bestrahlungsrichtungen erhöht werden kann. Hierbei ist die Energie der Ionen so gewählt, dass diese die Folie vollständig durchqueren. Die Energie des Ionenstrahls ist somit abhängig von der Dicke der zu bestrahlenden Folie.

Bevorzugt wird eine leitfähige Metallschicht als, ggf. temporäre, Kathodenschicht auf eine erste Seite der Templatfolie aufgebracht und zwar vorzugsweise nachdem die Ionenbestrahlung vorgenommen wird, weiter vorzugsweise vor dem Ätzen, zumindest aber vor der elektrochemischen Abscheidung. Vorzugsweise werden also die Nanoporen aus den latenten ioneninduzierten Spuren geätzt, nachdem die Kathodenschicht zumindest teilweise auf der Templatfolie aufgebracht ist. Auf diese Weise wird verhindert, dass sich Material der Kathodenschicht in den Poren abscheiden kann. Zudem sind die Poren insbesondere streng zylindrisch und weisen keine Verengung an den beiden Enden auf.

Vorzugsweise wird zur Herstellung der Kathodenschicht zunächst auf der ersten Seite der Templatfolie eine dünne Metallschicht, z.B. Goldschicht aufgesputtert und nachfolgend wird diese Goldschicht elektrochemisch z.B. mit einer Kupferschicht verstärkt. Dies hat den Vorteil, dass zunächst eine relativ dünne Schicht aufgesputtert werden kann.

In dem Schritt (c) wird nun die Templatfolie einem Ätzprozess unterworfen, mittels welchem die latenten Spuren in der Templatfolie zu durchgehenden Kanälen aufgeweitet werden, welche die Templatfolie vollständig durchdringen, also von einer Oberfläche der Templatfolie zu der gegenüberliegenden Oberfläche der Templatfolie reichen. Diese Kanäle werden in der Fachwelt als Nanoporen bezeichnet. Am Anfang des Ätzprozesses wird dabei der am meisten geschädigte Teil der Molekularstruktur im Spurkern herausgelöst und mit zunehmender Ätzdauer vergrößert sich der Durchmesser der Nanoporen. Aufgrund der Bestrahlung der Templatfolie aus unterschiedlichen Richtungen und dem daraus resultierenden gekreuzten Netzwerk aus latenten Spuren entsteht beim Ätzen ein Netzwerk aus gekreuzten Nanoporen. Die gekreuzten Nanoporen sind insbesondere so dicht angelegt, dass sich ein erheblicher Anteil der gekreuzten Nanoporen miteinander verbindet, so dass ein verbundenes Kanalsystem mit vielen Verzweigungen entsteht. Wenn aus zumindest drei Richtungen, welche nicht in einer gemeinsamen Ebene liegen, bestrahlt wurde, entsteht ein dreidimensional vernetztes Kanalsystem aus Nanoporen.

In einem nachfolgenden Schritt (d) werden, beginnend auf der Innenseite der Kathodenschicht, in den Nanoporen innerhalb der Templatfolie Nanodrähte mittels elektrochemischer Abscheidung gezüchtet, d.h. die Nanoporen werden von der Kathodenschicht mittels der elektrochemischen Abscheidung gefüllt, wobei die Nanodrähte in den Nanoporen wachsen. Hierzu wird die mit den Poren durchsetzte und einseitig leitfähig beschichtete dielektrische Folie in eine elektrochemische Abscheidevorrichtung eingesetzt, wobei die Kathodenschicht als Kathode für den elektrochemischen Abscheidevorgang der Nanodrähte dient. Mittels elektrochemischer Abscheidung von Metallionen werden nun die Nanodrähte in den Nanoporen gezüchtet, wobei die Nanodrähte aus Metall innerhalb der Nanoporen, insbesondere unmittelbar, auf die Kathodenschicht aufwachsen und dabei mit der Kathodenschicht verwachsen. Die Kathodenschicht kann als eine mit den einzelnen Nanodrähten fest verbundene Substratschicht des zu erzeugenden Nanodraht-Strukturelements verbleiben, kann aber auch, falls gewünscht, nach dem Erzeugen des Nanodraht-Netzwerks wieder entfernt werden. In dem vermaschten Netzwerk aus Nanoporen oder Nanokanälen entsteht hierbei ein vermaschtes Netzwerk aus gekreuzten Nanodrähten. An den Knotenpunkten an denen die Nanoporen miteinander verbunden sind, entstehen demnach Knotenpunkte des Nanodraht-Netzwerks, an denen die gekreuzten Metall-Nanodrähte miteinander verwachsen bzw. sich integral miteinander verbinden. Somit kann ein integrales Netzwerk aus miteinander verbundenen gekreuzten Nanodrähten erzeugt werden. Die Templatfolie ist in diesem Verfahrensstand wie bei einer Armierung von dem Verbund-Netzwerk aus gekreuzten und miteinander verbundenen Nanodrähten durchsetzt.

Die Nanodrähte weisen einen Durchmesser von kleiner oder gleich 2000 nm auf.

Die Nanodrähte wachsen also innerhalb der Nanoporen in der Templatfolie in zumindest drei oder mehr vordefinierten unterschiedlichen Richtungen, welche durch die

Bestrahlungsrichtungen vorgegeben sind. Wenn die Bestrahlung aus zumindest drei Richtungen erfolgt, welche nicht in einer gemeinsamen Ebene liegen, verlaufen also die Nanodrähte in dem Netzwerk entlang von zumindest drei vordefinierten unterschiedlichen Richtungen, welche nicht in einer gemeinsamen Ebene liegen, so dass ein dreidimensional vernetztes Nanodraht-Netzwerk hergestellt wird. Bei dem dreidimensional vernetzten Nanodraht-Netzwerk sind die Nanodrähte einer ersten der zumindest drei vordefinierten Richtungen demnach mit anderen Nanodrähten nicht nur einer zweiten vordefinierten Richtung, sondern auch mit Nanodrähten zumindest noch einer dritten Richtung verbunden, wobei die dritte Richtung nicht in der Ebene liegt, die durch die erste und zweite Richtung aufgespannt wird.

Wenn das Netzwerk aus Nanodrähten vollständig abgeschieden bzw. gewachsen ist, wird in einem Schritt (e) die Templatfolie, insbesondere chemisch, aufgelöst und damit das Netzwerk aus Nanodrähten freigelegt. Die Templatfolie wird beim Auflösen zumindest in so kleine Bestandteile zerlegt, dass diese Bestandteile aus dem von dem Nanodraht-Netzwerk durchsetzten Raum entfernt werden kann, ohne das Nanodraht-Netzwerk zu beschädigen. Ist die Templatfolie eine Kunststofffolie, kann diese z.B. mit einem Lösungsmittel aufgelöst werden. Aufgrund der Vermaschung des Netzwerkes bzw. der Verbindung der gekreuzten Nanodrähte miteinander besitzt das Verbund-Nanodraht-Netzwerk auch nach der Entfernung der Templatfolie eine inhärente Stabilität, und zwar bereits mit lediglich einer Deckschicht (Kathoden-/Substratschicht) und ggf. sogar ganz ohne Deckschichten. Das Verbund-Netzwerk aus den Nanodrähten bildet eine offenzellige zumindest eigenstabile Hohlraum-Struktur, die sich vorsichtig aber relativ gut handhaben lässt.

D.h. erfindungsgemäß kann sogar, wenn das Netzwerk aus Nanodrähten vollständig abgeschieden bzw. gewachsen ist, die Kathodenschicht wieder entfernt werden, falls dies gewünscht ist. Die Kathodenschicht wird dann insbesondere nach dem Abscheiden des Nanodraht-Netzwerks und vor dem Auflösen und Entfernen der Templatfolie wieder von der Templatfolie entfernt. Dies ist z.B. dann gut möglich, wenn die Kathodenschicht und das Nanodraht-Netzwerk an der Grenzfläche aus unterschiedlichen Metallen bestehen. Die Entfernung der Kathodenschicht ist jedoch nicht zwingend, sie kann auch mit dem Nanodraht-Netzwerk verbunden bleiben, wenn z.B. eine geschlossene mit dem Nanodraht-Netzwerk verbundene Deckschicht erwünscht ist. Wenn die Kathodenschicht an dem Nanodraht-Netzwerk verbleibt, bildet sie eine Substratschicht, die zusätzlich die Stabilität erhöht und das Nanodraht-Strukturelement noch besser handhabbar macht. Vorzugsweise bildet das Nanodraht-Strukturelement also eine flache mattenartige Form. Insbesondere ist es also möglich, ein flaches Nanodraht-Strukturelement herzustellen, welches auf zumindest einer Flachseite des Nanodraht-Netzwerks nicht mit einer Deckschicht versehen ist, also offen ist und die gegenüberliegende Flachseite des Nanodraht-Netzwerks fest mit der Substratschicht verbunden bzw. verwachsen ist. Hierbei sind die einzelnen Nanodrähte jeweils individuell mit der Substratschicht verbunden. Die Flachseiten des flachen mattenartigen Nanodraht-Strukturelements werden durch die Oberflächen der Templatfolie definiert. Durch die stabile Vernetzung (mechanische integrale Verbindung an den Knotenpunkten) der Nanodrähte ist es demnach auch möglich, ein Nanodraht-Netzwerk völlig ohne Deckschichten herzustellen.

Um eine hinreichende Nanodrahtdichte und Stabilität des Nanodraht-Netzwerks zu erhalten, wird die Ionenbestrahlung mit einer Intensität des Ionenstrahls durchgeführt, die hinreichend groß ist, dass sich eine hinreichende Anzahl der gekreuzten Nanoporen an Knotenpunkten überlappen, so dass die gekreuzten Nanodrähte an hinreichend vielen Knotenpunkten zu dem verbundenen Netzwerk miteinander verwachsen. Die Intensität des Ionenstrahls, genauer die Flächendichte (Anzahl der Ionen pro Flächeneinheit) pro Bestrahlungsrichtung sollte vorzugsweise zumindest $1 \cdot 10^7$ Ionen/cm$^2$, bevorzugt zumindest $5 \cdot 10^7$ Ionen/cm$^2$, besonders bevorzugt in der Größenordnung von $5 \cdot 10^8$ Ionen/cm$^2$ betragen. Die Intensität des Ionenstrahls sollte vorzugsweise zumindest so hoch sein, dass eine Vernetzung entsteht, bei der im Mittel zumindest ein Knotenpunkt, insbesondere sogar mehrere Knotenpunkte, pro Nanodraht erzeugt wird bzw. werden. Die Knotenpunkte liegen bei den gekreuzten Nanodrähten dabei zwischen den Enden der Nanodrähte und zwar aufgrund der stochastischen Verteilung der Ionen bei der Bestrahlung bei unterschiedlichen Nanodrähten an unterschiedlichen Stellen entlang der Länge der Nanodrähte.

Ein Vorteil der Erfindung liegt u.a. darin, dass ein Nanodraht-Netzwerk erzeugt werden kann, welches zumindest vier-seitig oder zumindest fünf-seitig oder sogar allseitig offen (wie ein Schwamm) und dennoch stabil und weitgehend selbsttragend hergestellt werden kann. Das Nanodraht-Netzwerk bildet also insbesondere ein stabiles bzw. selbsttragendes Nanodraht-Strukturelement. Nach der vollständigen Entfernung der Templatfolie bleibt demnach entsprechend ein strukturstabiles Hohlraum-Bauelement mit einer Nanodraht-Netzwerk-Struktur übrig.

Dieses Nanodraht-Strukturelement mit allseitig offenem Nanodraht-Netzwerk oder lediglich einseitig mit der Substratschicht geschlossene oder beidseits flachseitig geschlossene Nanodraht-Strukturelement eignet sich in hervorragender Weise z.B. als Mikroreaktor-Bauelement, insbesondere als Mikrokatalysator-Bauelement für die heterogene Katalyse. Außerdem besitzt das Nanodraht-Strukturelement eine große Langzeitstabilität, da die Nanodrähte an einer Vielzahl von Knotenpunkten fest miteinander verankert sind und nicht z.B. lose in Mikrokanälen liegen. Selbst wenn sich einzelne Knotenpunkte lösen sollten, ist die Anzahl der verbleibenden Knotenpunkte immer noch ausreichend, um die Stabilität des Netzwerkes zu gewährleisten.

Die Nanodrähte werden vorzugsweise gepulst abgeschieden. Die gepulste Abscheidung umfasst zumindest folgende Alternativen:

1) Die Abscheidung erfolgt mittels Pulsabscheidung, d.h. Abscheidepulse und abscheidungsfreie Diffusionszeiträume wechseln sich ab.
2) Die Abscheidung erfolgt mittels Umkehrpulsabscheidung, d.h. Abscheidepulse und anodische Gegenpulse wechseln sich ab.

Beide Alternativen haben den Vorteil, dass in den Pausen zwischen den Abscheidepulsen in der Elektrolytlösung Ionen in die Nanoporen nachdiffundieren können, was zu einem einheitlicherem Wachstum der Nanodrähte führt.

Die Kathodenschicht kann mittels eines an sich bekannten Beschichtungsverfahrens, welches zum Aufbringen einer leitfähigen, z.B. metallischen Schicht, geeignet ist, erzeugt werden (z.B. Bedampfen, PVD, Sputtern etc.). Die Kathodenschicht kann dabei einschichtig erzeugt werden. Vorzugsweise wird die Kathodenschicht allerdings zumindest zweischichtig erzeugt, wobei die erste Teilschicht z.B. mittels PVD, z.B. Aufsputtern oder Aufdampfen, abgeschieden wird und diese erste Teilschicht dann mittels elektrochemischer Abscheidung mit einer zweiten Teilschicht gegebenenfalls aus einem anderen Material, z.B. Kupfer auf Gold, verstärkt wird.

Das Ergebnis des vorstehend beschriebenen Herstellungsverfahrens ist demnach ein Nanodraht-Strukturelement mit einer Hohlraumstruktur, welche ein Array aus einer Vielzahl von gekreuzt oder unter Winkeln angeordneten Nanodrähten umfasst, die an einer Vielzahl von Knotenpunkten miteinander verwachsen sind. Verwachsen bedeutet in diesem Zusammenhang, dass die Nanodrähte durch den elektrochemischen Abscheidevorgang auf atomarer/molekularer Ebene integral miteinander verbunden sind. Das vermaschte Nanodraht-Netzwerk ist also ein einheitliches gewachsenes Materialsystem aus elektrochemisch abgeschiedenem Material.

Zwischen den Nanodrähten in dem Nanodraht-Netzwerk befinden sich Zwischenräume, welche miteinander verbunden sind. Die Hohlraumstruktur die das Nanodraht-Netzwerk bildet, ist demnach offenzellig, so dass ein Fluid durch die offenzellige Hohlraumstruktur geleitet werden kann, um mit den Zylinderflächen der Nanodrähte, welche eine große Oberfläche bilden, in Wechselwirkung zu treten.

Durch das Herstellungsverfahren ergeben sich aber noch weitere bestimmte strukturelle Eigenschaften des erzeugten Nanodraht-Strukturelements. Dadurch dass die Nanodrähte bzw. das Nanodraht-Netzwerk aus elektrochemisch abgeschiedenem Material gewachsen sind, können sie eine spezifische Kristallstruktur haben, die z.B. mittels Röntgendiffraktion untersucht werden kann. Somit kann anhand der Kristallstruktur erkennbar sein, ob das Nanodraht-Netzwerk mit dem beschriebenen Verfahren hergestellt wurde.

Der Durchmesser der Nanodrähte ist kleiner oder gleich 2000 nm, besonders bevorzugt kleiner oder gleich 500 nm bzw. kleiner oder gleich 100 nm. Derzeit erscheinen Durchmesser bis hinunter zu 10 nm oder sogar noch kleiner herstellbar zu sein. Je größer das Aspektverhältnis der Nanodrähte ist, desto größer läßt sich die aktive Oberfläche des Nanodraht-Strukturelements erzeugen. Das Aspektverhältnis der Nanodrähte ist daher vorzugsweise größer oder gleich 1 zu 50, besonders bevorzugt größer oder gleich 1 zu 100. Weiter bevorzugt ist der mittlere Abstand der Nanodrähte voneinander größer als der mittlere Durchmesser der Nanodrähte.

Die Dicke des Nanodraht-Strukturelements wird durch die Dicke der Templatfolie definiert. Aufgrund der Flächigkeit der Templatfolie ist das Nanodraht-Strukturelement vorzugsweise ebenfalls flächig oder in Form einer dünnen Matte. Die Dicke des Nanodraht-Netzwerks ist vorzugsweise kleiner oder gleich 200 $\mu$m, besonders bevorzugt kleiner oder gleich 50 $\mu$m. Die Ausdehnung in den beiden Dimensionen der Ebene senkrecht zur Dicke kann ein Vielfaches hiervon betragen. Es ist z.B. möglich ein derartiges Nanodraht-Netzwerk mit einer Fläche von 0,5 cm$^2$ herzustellen.

Die Flächendichte der Anzahl der Nanodrähte entspricht in etwa der Bestrahlungsdichte (Ionen/cm$^2$) und ist ebenfalls ein Maß für die aktive Oberfläche. Die Flächendichte der Anzahl der Nanodrähte ist vorzugsweise größer oder gleich n/F = 10$^7$ cm$^{-2}$, besonders bevorzugt größer oder gleich n/F = 10$^8$ cm$^{-2}$.

Als spezifisches Maß für die aktive Oberfläche des Nanodraht-Strukturelements, kann die geometrische spezifische Oberfläche der Nanodrähte pro Fläche des Nanostrukturelements und pro Dicke des Nanodraht-Arrays dienen. Diese geometrische spezifische Oberfläche $A_V$ ist demnach etwa

$$A_V = \pi \cdot \frac{nD}{F \cos \alpha} \, ,$$

wobei D der mittlere Durchmesser der Nanodrähte, n/F die Flächendichte der Nanodrähte und $\alpha$ der mittlere Winkel der Nanodrähte zur Flächennormalen der Templatfolie ist.

Die geometrische spezifische Oberfläche $A_V$ pro Fläche und Dicke wird gebildet durch die Summe der Nanodrähte und sollte mindestens 1 mm$^2$/(cm$^2$ $\mu$m) betragen; bevorzugt sind jedoch größere Werte, nämlich $A_V$ größer oder gleich 5 mm$^2$/(cm$^2$ $\mu$m), größer oder gleich 20 mm$^2$/(cm$^2$ $\mu$m) oder sogar größer oder gleich 100 mm$^2$/(cm$^2$ $\mu$m). Ggf. können sogar Werte bis 1000 mm$^2$/(cm$^2$ $\mu$m) erreicht werden.

Bei Herstellung der Nanodrähte mit dem Umkehrpulsverfahren besitzen die Nanodrähte eine deutliche <100>-Textur, bzw. eine kristallitische Struktur. Für bestimmte Metalle, wie z.B. Gold kann es vorteilhaft sein, möglichst kleine Kristallite zu erzeugen. Hierfür wird bevorzugt, eine Kristallitgröße von kleiner oder gleich 4 nm zu erzielen, wobei allgemein bereits eine mittlere Kristallitgröße von kleiner oder gleich 10 nm von Vorteil sein kann.

Durch die kristallitische Textur ist die tatsächliche Größe der Oberfläche, insbesondere der aktiven Oberfläche, größer als die geometrische spezifische Oberfläche $A_V$, die auf der glatten Zylinderoberfläche basiert, und zwar vorliegend vorzugsweise etwa um einen Faktor 4 bis 5.

Ein besonders bevorzugtes Anwendungsfeld für die erfindungsgemäß hergestellten Nanodraht-Strukturelemente ist die heterogene Katalyse. D.h. ein oder mehrere Nanodraht-Strukturelemente dienen als Katalysator-Bauelemente, insbesondere für Mikrokatalysatoren.

Ein Mikrokatalysator umfasst vorzugsweise ein mikrostrukturiertes Kanalsystem mit einer Fluidzuführung und einer Fluidabführung und zumindest ein Nanodraht-Strukturelement als Katalysatorelement zwischen der Fluidzuführung und der Fluidabführung, so dass Fluid aus der Fluidzuführung in die Hohlraumstruktur des Nanodraht-Netzwerks eingeleitet, durch die Zwischenräume zwischen den Nanodrähten hindurch geleitet und durch die Fluidabführung wieder aus der Hohlraumstruktur abgeführt werden kann. Hierbei bildet die offenzellige Hohlraumstruktur des Nanodraht-Strukturelements das katalytische Reaktionsvolumen und die Zylinderflächen der Nanodrähte bilden die katalytisch aktive Oberfläche mit der das Fluid innerhalb der Hohlraumstruktur wechselwirkt. Vorzugsweise sind die Nanodrähte aufgrund der Abscheidung massiv (vollständig aus demselben Material) ausgebildet, z.B. aus Platin, so dass das Katalysatorelement ein Vollkatalysatorelement ist.

Wenngleich es aufgrund der besonderen Stabilität des Nanodraht-Netzwerks gerade nicht zwingend notwendig ist, beidseits auf beiden Flachseiten des Nanodrahtstruktur-Elements Deckschichten anzubringen, soll dies nicht ausgeschlossen sein, falls es erwünscht wird. Wenn zwei Deckschichten erwünscht sind, wird z.B. wie folgt vorgegangen: Der elektrochemische Abscheideprozess der Nanodrähte wird zumindest so lange fortgeführt, bis sich auf der zweiten Seite der Templatfolie Kappen auf den Nanodrähten ausgebildet haben und diese Kappen zu einer zweiten flächig geschlossenen Deckschicht auf der gegenüberliegenden Seite der Kathodenschicht zusammen wachsen. Diese flächig geschlossene Deckschicht gewinnt mit zunehmender Abscheidedauer an Dicke. Man kann also nun den elektrochemischen Abscheidevorgang mit dem die Nanodrähte erzeugt oder gezüchtet werden, demnach einfach so lange fortführen, bis die zweite Deckschicht in Form einer hinreichend dicken, stabilen, flächig geschlossenen Schicht gewachsen ist. Die Nanodrähte sind hierbei aufgrund der elektrochemischen Abscheidung beidseitig mit der jeweiligen Deckschicht unmittelbar fest verwachsen. Die Deckschicht kann, falls gewünscht, aber auch in einem separaten zweiten nachfolgenden Abscheidevorgang verstärkt und vervollständigt werden. Der separate zweite Abscheidevorgang kann ebenfalls eine elektrochemische Abscheidung sein, kann aber auch ein Beschichtungsverfahren, z.B. PVD-Verfahren, Aufdampfen oder Aufsputtern umfassen. Auch wenn der separate Abscheidevorgang eine elektrochemische Abscheidung ist, kann für die zweite Teilschicht ein anderes Material als für die Nanodrähte und die Kappen verwendet werden. Besonders hat es sich bewährt, die Nanodrähte und die Kappen mit einem gepulsten elektrochemischen Abscheideverfahren zu erzeugen und die zweite Teilschicht mit einem Gleichstromverfahren elektrochemisch abzuscheiden. Insbesondere werden die Nanodrähte und ggf. die Kappen mit einer Umkehrpulsabscheidung aus einem Metall oder einer metallhaltigen Verbindung erzeugt. Z.B. hat es sich bewährt, die Nanodrähte und ggf. die Kappen mit Umkehrpulsabscheidung aus Platin und die zweite Teilschicht mit Gleichstromabscheidung aus Kupfer zu erzeugen. Hierdurch können die Abscheidezeit verkürzt und die Materialkosten gesenkt werden. Die Dicke der Substratschicht und der Deckschicht beträgt vorzugsweise jeweils weniger als 10 μm, z.B. etwa 5 μm bis 10 μm.

Aus einzelnen Nanodraht-Strukturelementen kann ein Sensorelement aufgebaut werden. Das Sensorelement ist beispielsweise geeignet oder vorgesehen zum Messen von einem Gasdurchfluss und Temperatur. Ferner kann das Sensorelement auch als Bewegungssensor dienen. Das Sensorelement weist auf: mindestens eine Messeinheit, die ein erstes Nanodraht-Strukturelement und ein zweites Nanodraht-Strukturelement aufweist, wobei die Nanodraht-Strukturelemente jeweils eine erste Substratschicht und eine zweite Substratschicht zum Kontaktieren des jeweiligen Nanodraht-Strukturelement aufweisen. Zwischen den Nanodraht-Strukturelementen ist ein "heizbares/erwärmbares Element" angeordnet. Das Heizen erfolgt beispielsweise durch Anlegen einer Spannung an das Element, das beispielsweise ein heizbarer Mikrodraht ist. Hierbei ist bevorzugt jedes Nanodraht-Strukturelement einzeln kontaktiert. Wird ein Gas durch das Sensorelement geleitet, wird das Gas an dem geheizten Element erwärmt und erwärmt das hinter dem Element liegende Nanodraht-Strukturelement, wodurch eine Änderung des Widerstandes des Sensorelementes erfolgt oder induziert wird. Somit ist die Widerstandsänderung ein Maß für den Gasdurchfluss durch das Sensorelement. Die Widerstandsänderung kann ebenfalls ein Maß für die durch den Gasdurchfluss beeinflußte Temperaturänderung sein. Wird das Sensorelement bewegt, zeigt die Widerstandsänderung eine Bewegungsänderung an. Das Gas durchquert hierbei zuerst das erste Nanodraht-Strukturelement, dann das heizbare Element und dann das zweite Nanodraht-Strukturelement. Das Sensorelement ist beispielsweise mit einer Maske bei der Bestrahlung des verwendeten Templates herstellbar, also einem Verfahren gemäß Anspruch 5.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

Kurzbeschreibung der Figuren

Es zeigen:

Fig. 1 eine schematische Übersicht über die Herstellung eines Nanodraht-Strukturelements mit Nanodraht-Netzwerk,

Fig. 2 eine dreidimensionale Darstellung der zur elektrochemischen Abscheidung verwendeten Abscheidevorrichtung,

Fig. 3 eine dreidimensionale transparente Explosionsdarstellung der Abscheidevorrichtung für die Abscheidung der Kathodenschicht,

Fig. 4 eine dreidimensionale transparente Explosionsdarstellung der Abscheidevorrichtung für die Abscheidung der Nanodrähte und ggf. einer Deckschicht,

Fig. 5 eine REM-Aufnahme eines Nanodraht-Strukturelements mit zwei-dimensionalem Nanodraht-Netzwerk,

Fig. 6 eine REM-Aufnahme des Nanodraht-Strukturelements aus Fig. 5 mit stärkerer Vergrößerung,

Fig. 7 eine schematische Übersicht über die Herstellung eines Nanodraht-Strukturelements mit dreidimensionalem (3-D) Nanodraht-Netzwerk,

Fig. 8 eine TEM-Aufnahme eines dreidimensionalen Nanodraht-Netzwerks,

Fig. 9 eine REM-Aufnahme des dreidimensionalen Nanodraht-Netzwerks aus Fig. 8 mit geringerer Vergrößerung,

Fig. 10 eine REM-Aufnahme des dreidimensionalen Nanodraht-Netzwerks aus Fig. 8 und 9 mit noch geringerer Vergrößerung,

Fig. 11 eine schematische Explosionsdarstellung eines Mikroreaktors mit dem Nanodraht-Strukturelement für den Durchflussbetrieb, und

Fig. 12 eine schematische Darstellung eines Sensorelements mit zwei Nanodraht-Strukturelementen.

## Detaillierte Beschreibung der Erfindung

### Übersicht über das Herstellungsverfahren

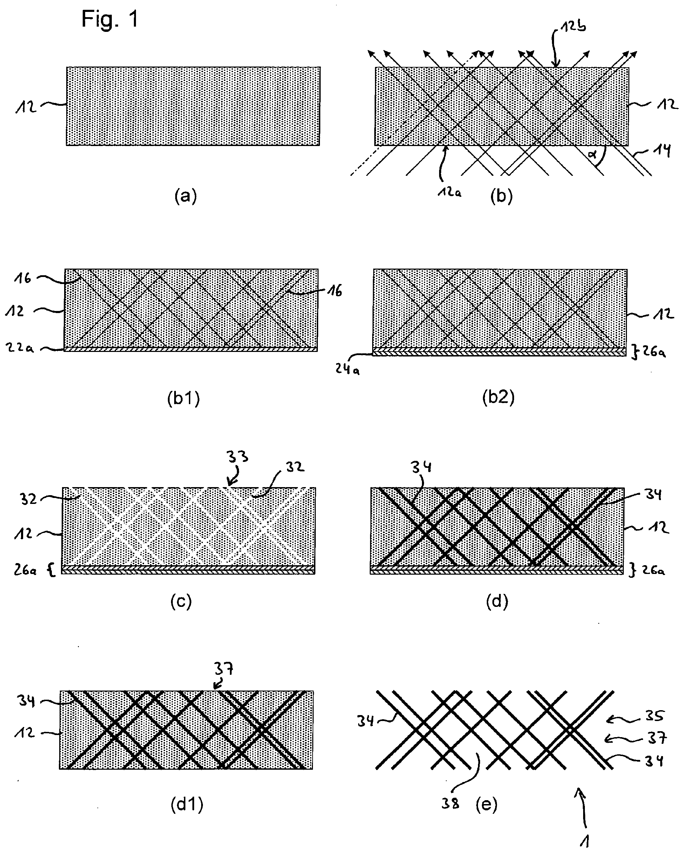

Die Herstellung des Nanodraht-Strukturelements basiert auf einem templatbasierten Verfahren. Die Teilschritte des Verfahrens sind in Fig. 1 schematisch wie folgt dargestellt:

(a) Bereitstellen der Templatfolie,
(b) Beschuss mit Ionen,
(b1) Aufbringen einer Goldschicht,
(b2) elektrochemisches Verstärken der Goldschicht (optional),
(c) Ätzen der Ionenspuren zu Nanoporen,
(d) Abscheiden der Nanodrähte in den Nanoporen,
(d1) Entfernen der Kathodenschicht (optional),
(e) Auflösen und Entfernen der Templatfolie.

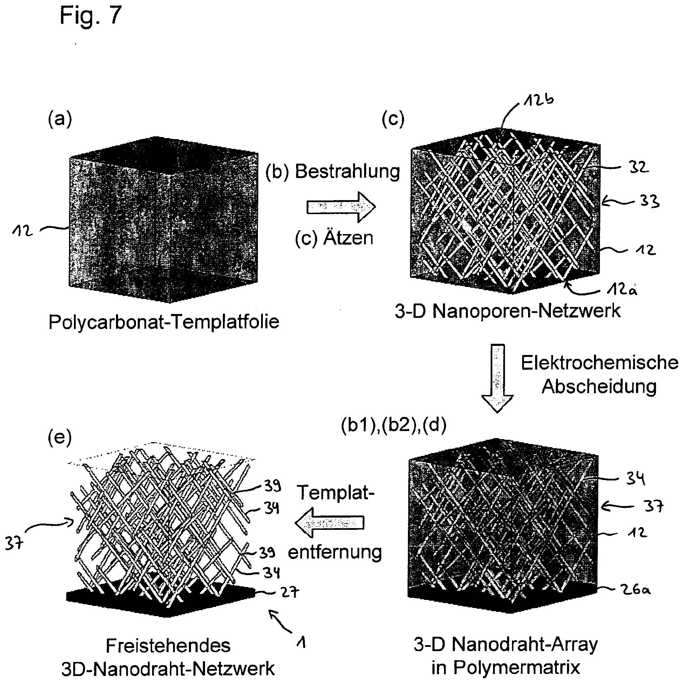

Vorzugsweise werden die Verfahrensschritte in der in Fig. 1 dargestellten Reihenfolge, d.h. (a), (b), (b1), (b2), (c), (d), (d1), (e) durchgeführt. Es ist aber grundsätzlich auch möglich, eine andere Reihenfolge zu verwenden, z.B. von zwei Seiten zu ätzen und anschließend erst die Kathodenschicht aufzubringen Teilschritt ((c) vor Schritten (b1) und (b2)) (vgl. z.B. Fig. 7).

Bezug nehmend auf Fig. 1 (b) wird zunächst eine Templatfolie 12 mit Ionen 14 beschossen, wobei entlang der Trajektorien latente Ionenspuren 16 im Material der Templatfolie 12 erzeugt werden (b1). Die Templatfolie 12 ist in diesem Beispiel eine Polymerfolie, genauer eine Polycarbonatfolie. Eine Besonderheit des hier beschriebenen Verfahrens liegt darin, dass die Templatfolie unter mehreren, in diesem Beispiel zwei Winkeln mit den Ionen bestrahlt wird. In diesem Beispiel wird die Templatfolie einmal unter +45° und einmal unter -45° bezogen auf die Oberfläche der Templatfolie bestrahlt, so dass die latenten Spuren und später die gekreuzten Nanoporen bzw. gekreuzten Nanodrähte in einem Winkel von 90° zueinander verlaufen. Selbstverständlich sind auch andere Winkel möglich.

Zur nacheinander folgenden Bestrahlung der Templatfolie 12 unter verschiedenen Winkeln wird die Templatfolie 12 zunächst unter einem ersten Winkel zur Richtung des Ionenstrahls an einem entsprechenden Strahlrohr, z.B. am Synchrotron der GSI, positioniert und mit einer vordefinierten ersten Ionen-Flächendichte bestrahlt.

Anschließend wird die Templatfolie 12 relativ zur Strahlrichtung gekippt und mit einer vordefinierten zweiten Ionen-Flächendichte nochmals bestrahlt. Wenn unter weiteren Winkeln Nanodrähte erzeugt werden sollen, wird der Vorgang so oft wiederholt, wie Winkel erwünscht sind. Die Ionendichte bzw. Flächendichte der Ionen, die für eine bestimmte Flächendichte von Nanodrähten notwendig ist, wird vorher berechnet und festgelegt. Die Bestrahlung erfolgt dann mit dieser vordefinierten Ionen-Flächendichte. Zur Herstellung eines 3-D Netzwerkes wie nachfolgend erläutert ist, wird z.B. die unter einem Polarwinkel zur Strahlachse positionierte Templatfolie 12 um die Strahlachse azimutal gedreht.

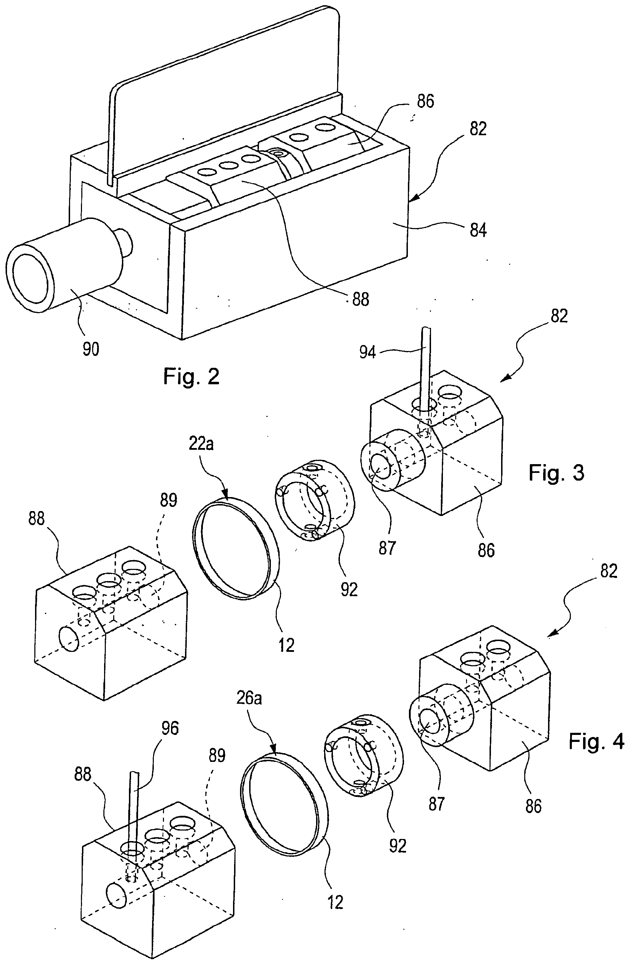

Nachfolgend wird auf der ersten Seite 12a der Templatfolie 12 eine dünne, leitende Metallschicht 22a, z.B. Gold aufgesputtert (b1), welche eine erste Teilschicht bildet. Anschließend wird die erste Teilschicht 22a mit einer zweiten Teilschicht 24a elektrochemisch verstärkt, wobei die erste und zweite Teilschicht zusammen die Kathodenschicht 26a bilden (b2), die später als Kathode zur Nanodrahtabscheidung dient (d). Zur elektrochemischen Abscheidung der zweiten Teilschicht 24a wird die Templatfolie 12 in die in Fig. 2-4 gezeigte Abscheidevorrichtung 82 eingespannt.

Anschließend wird die einseitig beschichtete Templatfolie 12 wieder aus der Abscheidevorrichtung 82 entfernt, und die latenten Ionenspuren 16 werden chemisch geätzt, wodurch durchgehende gekreuzte Kanäle gebildet werden. Diese Kanäle werden als Nanoporen bezeichnet und bilden aufgrund ihrer unterschiedlich verlaufenden Richtungen in der Templatfolie 12 gekreuzte und miteinander vernetzte Nanoporen 32. Alternativ kann der Ätzprozess auch in der Abscheidevorrichtung 82 erfolgen, indem die Ätzlösung in die entsprechende Zelle 88 eingefüllt und nach Abschluss der Ätzung wieder entfernt wird. Eine Entfernung der Templatfolie und der erneute Einbau sind nicht erforderlich. Der Durchmesser der Nanoporen 32 kann mittels Steuerung der Ätzzeit kontrolliert werden (c).

Nachfolgend wird die so vorbereitete, mit dem gekreuzten Netzwerk 33 aus Nanoporen 32 durchsetzte Templatfolie 12 wieder in die Abscheidevorrichtung 82 eingespannt und in einem zweiten elektrochemischen Prozess wird das gewünschte Metall unter Ausbildung eines Netzwerks 37 aus Nanodrähten 34 in die Nanoporen 32 elektrochemisch abgeschieden (d). In diesem Beispiel wird Platin in die Nanoporen abgeschieden, so dass die Nanodrähte 34 bzw. das Nanodraht-Netzwerk 37 aus Platin bestehen bzw. besteht. Dieses Platin-Nanodraht-Netzwerk 37 stellt aufgrund der katalytisch aktiven Oberfläche der Platin-Nanodrähte 34 ein katalytisch aktives Netzwerk dar.

Nach dem Abscheiden der Nanodrähte bzw. der Erzeugung des Nanodraht-Netzwerks 37 in der Templatfolie 12 kann die Kathodenschicht 26a wieder entfernt werden, falls dies gewünscht ist (d1). Die Entfernung der Kathodenschicht 26a wird vorteilhafterweise durchgeführt, bevor die Templatfolie 12 aufgelöst und entfernt wird. Die in diesem Beispiel verwendete Gold-Kathodenschicht lässt sich von den Platin-Nanodrähten gut wieder entfernen. Die Kathodenschicht 26a kann jedoch auch auf der Templatfolie 12 verbleiben und bildet nach dem Auflösen und Entfernen der Templatfolie eine Substratschicht 27, auf welcher das Nanodraht-Netzwerk 37 angeordnet und mit dieser fest verbunden ist (vgl. nachfolgend Fig. 7).

Schließlich wird die Polymerfolie 12 in einem geeigneten organischen Lösungsmittel aufgelöst (e). Das hiermit erfindungsgemäß hergestellte Metall-Nanodraht-Strukturelement 1 ist schematisch in Fig. 1(e) dargestellt.

Das Nanodraht-Strukturlelement 1 umfasst ein oder besteht aus einem Nanodraht-Array 35 aus gekreuzten, zusammengewachsenen Nanodrähten 34, die ein integrales vermaschtes Nanodraht-Netzwerk 37 bilden. Das Netzwerk 37 weist aufgrund der vermaschten Struktur der zusammengewachsenen Nanodrähte auch ohne Deckschichten, also allseits offen, bereits eine gewisse Eigenstabilität auf, wenngleich derartige Deckschichten, z.B. einseitig (Substratschicht 27) oder beidseitig zur Bildung einer Sandwichstruktur nicht ausgeschlossen sein sollen.

Die templatbasierte Methode bietet den Vorteil, dass viele Parameter gezielt beeinflusst werden können. Die Länge der Nanodrähte 34 wird durch die Dicke des verwendeten Templats 12 und den Bestrahlungswinkel bestimmt und beträgt vorzugsweise 10 bis 200 $\mu$m, besonders bevorzugt etwa 50 $\mu$m $\pm$ 50%. Die Flächendichte der Nanodrähte 34 wird durch die Bestrahlung festgelegt. Die Mindest-Flächendichte der Ionenbestrahlung und damit der Nanoporen sollte so gewählt werden, dass ein hinreichender Anteil der Nanodrähte 34 miteinander verwachsen kann. Diesbezüglich liegt eine bevorzugte Flächendichte für die Herstellung der Arrays bevorzugt zwischen etwa $1 \cdot 10^7$ cm$^{-2}$ bis $1 \cdot 10^9$ cm$^{-2}$. Der Durchmesser D der Nanodrähte 34 wird durch die Dauer der Ätzung eingestellt und kann von etwa 20 nm bis 2000 nm reichen. Das Aspektverhältnis der Nanodrähte 34 kann Werte von bis zu 1000 annehmen.

Als Materialien für die Nanodrähte 34 können elektrisch leitfähige Materialien, insbesondere Metalle oder metallhaltige Verbindungen, die sich zur elektrochemischen Abscheidung eignen, verwendet werden. Erfahrung wurde mit folgenden Metallen gesammelt, die sich als geeignet erwiesen haben: Cu, Au, Bi, Pt, Ag, Cu, Cu/Co Multilayer, Bi$_2$Te$_3$.

Einerseits ist eine hohe Anzahl an Nanodrähten 34 mit geringem Durchmesser D wünschenswert, um ein große aktive Oberfläche zu erhalten, andererseits soll eine gute mechanische Stabilität erzielt werden. Diese Optimierung ist vom Material abhängig und wird den Erfordernissen angepasst.

Für Nanodraht-Strukturelemente 1 mit Platin-Nanodrähten 34 wurde z. B. eine stabile Ausführung mit $10^8$ Drähten pro cm$^2$, die einen Durchmesser von 250 nm und eine Länge von 30 $\mu$m besitzen, hergestellt. Das Aspektverhältnis betrug hier 120. Solche Nanodraht-Strukturelemente eignen sich aufgrund der katalytischen Eigenschaften, z.B. des Platins oder der anderen enthaltenen Elemente als Katalysatorelemente.

Beispiel 1 (Vergleichsbeispiel)

Zur Herstellung eines Nanodraht-Strukturelements 1 wird eine 30 $\mu$m dicke, kreisförmige (r=1,5 cm) Polycarbonatfolie 12 (Makrofol®), die mit schweren Ionen 14 mit einer Energie von 11,1 MeV/u und unter zwei Winkeln (+45°,-45°) mit einer Fluenz von jeweils $5 \cdot 10^8$ Ionen/cm$^{-2}$ bestrahlt wurde, verwendet. Vor dem Aufbringen der leitenden Metallschicht 22a wird jede Seite der Polymerfolie 12 für eine Stunde mit UV-Licht bestrahlt, um die Selektivität der Ätzung entlang der Spuren 16 zu erhöhen.

Auf die erste Seite 12a der Polymerfolie 12 wird eine etwa 30 nm dicke Goldschicht 22a aufgesputtert (b1). Diese wird verstärkt, indem Kupfer aus einer auf CuSO$_4$ basierenden Elektrolytlösung (Cupatierbad, Riedel) potentiostatisch bei einer Spannung von U = -500 mV abgeschieden wird, wobei eine Kupferstabelektrode als Anode dient (Teilschicht 24a) (b2). Die Abscheidung wird nach 30 min beendet, wonach die Kupferschicht 24a ungefähr 10 $\mu$m dick ist. Im Anschluss wird bei 60 °C mit NaOH-Lösung (6 M) für einige zehn Minuten von der unbehandelten Seite 12b der Templatfolie 12 geätzt und mit entionisiertem Wasser gründlich gespült, um Reste der Ätzlösung zu entfernen (c). Nun wird die nanoporierte Templatfolie 12 in die Abscheidevorrichtung 82 eingespannt.

Die Abscheidung der Nanodrähte 34 erfolgt bei 65 °C mit einem alkalischen Pt-Elektrolyten (Pt-OH-Bad, Metakem). Zur Erzeugung der Nanodrähte 34 wird das Verfahren der Umkehrpulsabscheidung angewendet, um den langsamen diffusionsgetriebenen Massentransport in den Nanoporen 32 zu kompensieren und einheitliches Nanodrahtwachstum zu erzielen. Auf einen Abscheidungspuls mit U = -1,3 V für 4 s folgt ein anodischer Puls für 1 s bei U = +0,4 V. Nach einigen bis einigen zehn Minuten wird die Abscheidung gestoppt und das Wachstum kontrolliert. Die Nanodrähte 34 sind zu diesem Zeitpunkt ausreichend gewachsen und in den Nanoporen zusammengewachsen.

Schließlich wird das Templatmaterial entfernt, indem das ganze Nanodraht-Strukturelement 1 mit der Templatfolie 12 für mehrere Stunden in ein Gefäß mit 10 ml Dichlormethan gelegt wird. In diesem Beispiel verbleibt also die Kathodenschicht als Substrat 27 an dem Nanodraht-Array 35 und bildet einen Bestandteil des Nanodraht-Strukturelements 1. Das Lösungsmittel wird dreimal gewechselt, um Polymerreste aus dem Innenraum 38 des Nanodraht-Arrays 35 vollständig zu entfernen.

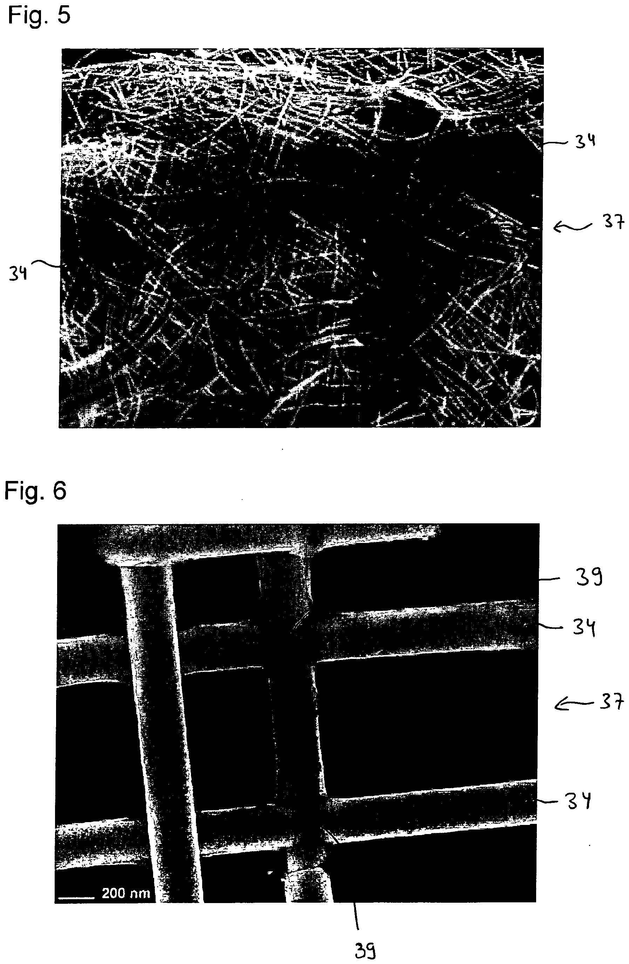

Ein derart hergestelltes Nanodraht-Strukturelement 1 ist in Raster-Elektronenmikroskopaufnahmen (REM) in den Fig. 5 und 6 zu sehen. Die Nanodrähte 34 haben hier einen Durchmesser von ungefähr 150 nm. Aufgrund der Bestrahlung unter zwei Winkeln wird das Netzwerk als 2-dimensional bezeichnet. In Fig. 5 und 6 ist also eine solche 2-D Nanodraht-Netzwerkstruktur zu sehen, welche in einem Templat hergestellt wurden, das zweimal unter Winkeln bestrahlt wurde (+45°, -45°). Es hat sich ein Netzwerk gebildet, das nach Entfernung der Polymermatrix bereits relativ stabil auf dem Substrat verteilt und mit diesem verbunden sind.

Die vergrößerte REM-Aufnahme einzelner Nanodrähte 34 gemäß Fig. 6 zeigt, dass die Nanodrähte 34 sehr schön an Knotenpunkten 39 miteinander verwachsen und somit fest verbunden sind und die durch die Bestrahlung vorgegebene Orientierung von 90° aufrechterhalten wird. Die Knotenpunkte 39, an denen die Nanodrähte 34 miteinander verwachsen sind, werden durch die Schnittpunkte der Nanoporen vorgegeben und liegen an einer oder mehreren Stellen über die Länge der Nanodrähte 34 verteilt, also zwischen den Enden der Nanodrähte 34.

Beispiel 2

Bezug nehmend auf die Fig. 7 bis 10 wurde ein weiteres Ausführungsbeispiel hergestellt. Fig. 7 zeigt schematisch und teilweise zusammengefasst folgende Teilschritte des Verfahrens:

(a) Bereitstellung der Templatfolie,
(b),(c) Bestrahlen und Ätzen der Ionenspuren zu Nanoporen,
(b1),(b2),(d) Erzeugen einer Kathodenschicht und Abscheiden der Nanodrähte in den Nanoporen,
(e) Auflösen und Entfernen der Templatfolie.

Bezug nehmend auf Fig. 7 wird die Templatfolie oder Polymermembran 12 hierbei aus mehr als zwei verschiedenen Richtungen bestrahlt. Die Bestrahlung erfolgt in diesem Beispiel unter vier verschiedenen Winkeln, wobei die vier Bestrahlungsrichtungen nicht in einer Ebene liegen. Bezogen auf die in Fig. 7 gezeigte perspektivische Ansicht wird je einmal von jeder der vier Seiten schräg von oben bestrahlt, und zwar unter einem Polarwinkel von 45° zur Normalen der Substratoberfläche und mit Azimutwinkeln von 0°, 90°, 180° und 270°. Die Templatfolie 12 wird also bei der Bestrahlung zumindest dreimal gedreht.

Wenn die Templatfolie aus zumindest drei Richtungen (in diesem Beispiel vier Richtungen), die nicht in einer gemeinsamen Ebene liegen, bestrahlt wird, lässt sich nämlich ein dreidimensionales Nanoporen-Netzwerk 33 (c) und nachfolgend ein dreidimensionales Nanodraht-Netzwerk 37 (d) und (e) herstellen. Mit anderen Worten liegen hierbei die Bestrahlungsrichtungen und damit die Nanodrähte 34 in mehreren verschiedenen (nicht parallelen) Ebenen, die schräg zur Templatoberfläche 12a, 12b verlaufen. Bei dem so erzeugten dreidimensionalen Nanodraht-Netzwerk 37 verlaufen demnach auch die Nanodrähte in verschiedenen nicht parallelen Ebenen, so dass eine dreidimensional vernetzte Netzwerk-Struktur vorliegt. Mathematisch ausgedrückt verlaufen die Nanodrähte also zumindest entlang von drei nicht parallelen Achsen, die zumindest zwei Ebenen aufspannen, die wiederum nicht parallel sind. Dadurch sind die Nanodrähte nicht nur mit anderen Nanodrähten aus derselben Ebene verbunden, sondern es sind auch Nanodrähte vorhanden, die schräg zu einer von diesen Nanodrähten gebildeten Ebene verlaufen. Anders ausgedrückt lässt sich mit den zumindest drei Achsen bzw. Nanodraht-Richtungen also in der Sprache der Vektormathematik ein dreidimensionaler Vektorraum aufspannen. Die zumindest drei Achsen bzw. Nanodraht-Richtungen sind linear unabhängig. Ein solches dreidimensional vernetztes Nanodraht-Netzwerk wird hier als dreidimensionales (3-D) Nanodraht-Netzwerk bezeichnet.

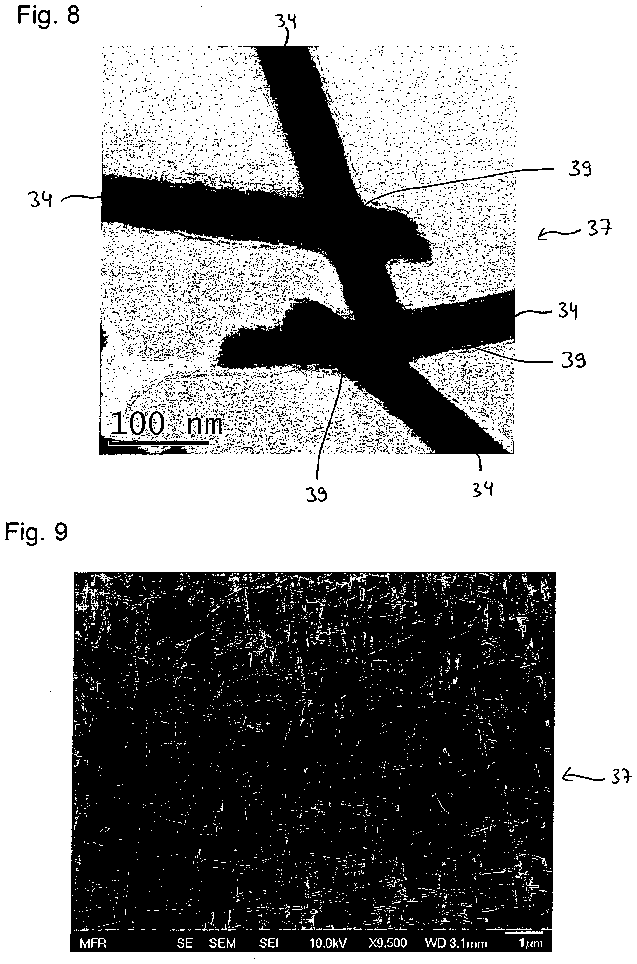

Fig. 8 zeigt eine transmissionsmikroskopische Aufnahme (TEM) und Fig. 9 eine REM-Aufnahme mit geringerer Vergrößerung eines solchen dreidimensionalen Nanodraht-Netzwerks 37, in denen zu erkennen ist, dass sich ein mechanisch stabiles, in sich zusammenhängendes System von unter vordefinierten Winkeln verlaufenden Nanodrähten 34 gebildet hat, das die durch die Polymermatrix vorgegebene Orientierung nach Templatentfernung in hohem Maße aufrecht erhält, wie insbesondere an der REM-Aufnahme in Fig. 9 zu erkennen ist. Das Templat 12 des gezeigten Netzwerkes 37 wurde durch viermalige Bestrahlung aus vier verschiedenen linear unabhängigen Richtungen mit je $5 \cdot 10^8$ Ionen pro cm² hergestellt. Die Dicke der Nanodrähte beträgt hier etwa 50 nm.

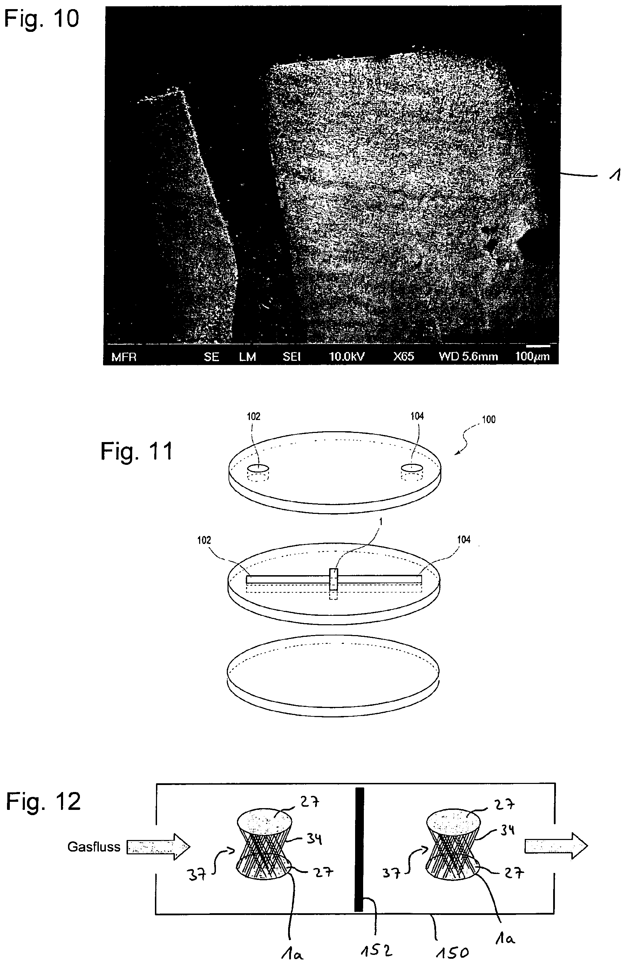

Aggregation und Verlust der aktiven Oberfläche wurden kaum beobachtet, was bedeutet, dass ausgezeichnete Zugänglichkeit und leichte Katalysatorrückgewinnung gegeben sind. Das Herstellungsverfahren ermöglicht eine einfache Kontrolle der Netzwerkparameter mittels Einstellung des Drahtdurchmessers, der Integrationsdichte und der Komplexität (Anzahl der unterschiedlichen Nanodrahtrichtungen) des Netzwerkes. Es können sehr große Nanodraht-Netzwerke 37, die in zwei Dimensionen mehrere Millimeter messen, hergestellt werden, wie z.B. in Fig. 10 zu erkennen ist. Fig. 10 zeigt eine REM-Aufnahme des etwa 1 cm² großen Nanodraht-Strukturelements aus Fig. 9. Das gesamte Nanodraht-Strukturelement 1 ist demnach makroskopisch groß. Am linken Rand der Aufnahme ist ein weiteres etwas kleineres Nanodraht-Strukturelement zu sehen. Die Pt-Nanodraht-Netzwerke haben eine große katalytisch aktive Oberfläche, ohne ein Trägersubstrat 27 zu benötigen, das aber nicht ausgeschlossen sein soll.

Das erfindungsgemäße Nanodraht-Strukturelement 1 weist demnach zu einem Netzwerk 37 verbundene Nanodrähte 34 auf, bei welchem die Netzwerkstruktur, insbesondere die 3-D Netzwerk-Strukturen eine Möglichkeit darstellen, Nanodrähte zu mikros- und sogar makroskopischen Strukturen mechanisch stabil zu verbinden. Die Stabilität ist so groß, dass sie sich ohne beidseitige Deckschichten, ggf. sogar ganz ohne Trägersubstrat zur Integration eignen. Nahezu alle Nanodrähte 34 sind nicht nur mechanisch fest, sondern elektrisch leitfähig miteinander verbunden, womit diese Strukturen ein großes Anwendungs-Potential für die Elektrokatalyse besitzen.

### Weiteres Beispiel für die Abscheideparameter

Bei einem anderen Beispiel wurde die Ätzzeit auf 18 min eingestellt, was Nanodrähte 34 ergab, die einen Durchmesser von ca. 250 nm besitzen. Die Flächendichte (Anzahl pro Fläche) betrug hierbei $10^8$ cm$^{-2}$. Zur elektrochemischen Abscheidung der Drähte wurde erneut die Umkehrpulsmethode verwendet. Auf einen Abscheidungspuls von $U_1 = -1,4$ V für 40 ms folgte ein kurzer Gegenpuls mit $U_2 = -0,1$ V für 2 ms und eine Pulspause von 100 ms bei einer Spannung von U = -0,4 V, was einer Überspannung von ca. 0 V entspricht. D. h. während des Gegenpulses befindet sich das System im Gleichgewichtszustand.

### Aufbau für die elektrochemische Abscheidung

Bezug nehmend auf die Fig. 2-4 erfolgt die elektrochemische Abscheidung des aus einer Vielzahl von Nanodrähten 34 bestehenden Nanodraht-Arrays 35 vollständig in der in Fig. 2 gezeigten Abscheidevorrichtung 82. Sie besteht aus einem Metallgehäuse 84, in das ein die beiden Elektrolysezellen 86, 88 fassender Metallschlitten geschoben werden kann. Aufgrund der guten Wärmeleitfähigkeit von Metall ist es möglich, die Abscheidevorrichtung durch kontrollierte externe Wärmezufuhr zu temperieren.

Die aus PCTFE gefertigten Elektrolysezellen 86, 88 besitzen auf den einander zugewandten Seiten jeweils eine gleich große kreisförmige Öffnung 87, 89 und können durch eine Handschraube 90 dicht aufeinander gepresst werden. Ein Kupferring 92 zwischen den beiden Elektrolysezellen 86, 88 dient als Kathode bzw. zum Kontaktieren der ersten Deckschicht für die elektrochemische Abscheidung.

Bezug nehmend auf Fig. 3 wird zur elektrochemischen Verstärkung der Teilschicht 22a die ionenspurgeätzte Templatfolie 12 so zwischen die beiden Elektrolysezellen 86, 88 montiert, dass die Teilschicht 22a, hier die aufgesputterte Goldschicht 22a, guten Kontakt mit der ringförmigen Kupferelektrode 92 hat. Auf beiden Seiten des als Kathode verwendeten Kupferringes werden Elektrolyte in die Elektrolysezellen gefüllt. Mit einer ersten Anode 94, welche in der der Teilschicht 22a zugewandten Elektrolysezelle 86 angeordnet ist, und externer Stromversorgung mit Steuergerät erfolgt die elektrochemische Verstärkung der Goldschicht 22a zur ersten Deckschicht 26a.

Nach Entnahme der Templatfolie 12 und Ätzung der Nanoporen 32 außerhalb der Abscheidevorrichtung 82 wird die Templatfolie 12 wieder in die Abscheidevorrichtung 82 eingesetzt.

Bezug nehmend auf Fig. 4 wird zur elektrochemischen Abscheidung der Nanodrähte 34 und ggf. einer Deckschicht gegenüber der Kathodenschicht 26a die einseitig beschichtete und mit Nanoporen versehene Templatfolie 12 wie in Fig. 3 wieder in die Abscheidevorrichtung 82 eingespannt, so dass die Kathodenschicht 26a Kontakt zu der Ringelektrode 92 hat. Nun wird auf der zweiten Seite 12b der Templatfolie 12 in der der Kathodenschicht 26a abgewandten Elektrolysezelle 88 mit einer hierin angeordneten zweiten Anode 96 abgeschieden.

### Untersuchung des Einflusses der elektrochemischen Abscheidebedingungen auf das Nanodrahtwachstum

Mit dem gepulsten Abscheideverfahren zur Erzeugung der Nanodrähte 34 kann vorteilhafterweise eine einheitliche Länge der Nanodrähte zu jedem Zeitpunkt der Abscheidung erreicht werden. Dies kann ohne Anspruch auf Vollständigkeit und Richtigkeit dadurch erklärt werden, dass die Diffusionsschichten im Vergleich zur Gleichstromabscheidung kurz gehalten werden. In den Pausen (Gleichgewichtszustand oder Gegenpuls) zwischen den Abscheidungspulsen können Metallionen in die Nanoporen 32 nachdiffundieren, sodass auf der gesamten Elektrodenoberfläche nahezu gleiche Konzentrationsverhältnisse zu Beginn eines jeden Abscheidungspulses vorliegen, was zu homogenem Wachstum führt. Die Diffusionsschichten überschneiden sich kaum und Unregelmäßigkeiten in der Oberfläche werden nicht verstärkt.

### Strukturelle Eigenschaften der Nanodrähte 34

Im Rahmen der Erfindung wurden auch die strukturellen Eigenschaften der Nanodrähte 34 aus verschiedenen Materialien untersucht. Bei elektrochemisch abgeschiedenem Material ist es z.B. möglich, die Größe der Kristallite zu kontrollieren. Dies hat Auswirkungen auf die mechanische Stabilität, die thermischen und elektrischen Transporteigenschaften sowie die Oberfläche und damit auch auf die katalytische Aktivität. Viele Eigenschaften können somit gezielt beeinflusst werden.

Insbesondere wurde die Struktur der Nanodrähte 34 mittels Röntgendiffraktion untersucht. Dazu wurde die Textur als Funktion der elektrochemischen Abscheidebedingungen analysiert.

Unter Gleichstrom hergestellte Pt-Nanodrähte 34 zeigen eine deutliche <100>-Textur. Der Texturkoeffizient $TC_{100}$ beträgt 2,32, wobei sein Maximalwert 3 ist. Die Größe der Kristallite wurde aus der Halbwertsbreite des Platin-Signals mit Hilfe der Scherrer-Formel bestimmt und betrug 8 nm. Für katalytische Anwendungen ist eine möglichst kleine Größe der Kristallite wünschenswert. Der hier angegebene Wert liegt in der Größenordnung der sonst in der Katalyse eingesetzten Nanopartikel. Es wird davon ausgegangen, dass die Kristallitgröße durch veränderte elektrochemische Abscheidebedingungen noch verkleinert werden kann.

Untersucht man Nanodrähte 34, die unter Pulsabscheidung hergestellt wurden, so findet man keine besondere Textur. Die Signalintensitäten entsprechen denen von polykristallinem Platin.

Schließlich ist eine Probe, die mit Umkehrpulsen hergestellt wurde, analysiert worden. Es zeigt sich erneut eine deutliche <100>-Textur, wobei der Texturkoeffizient $TC_{100}$ 4,16 ist. Die Kristallite weisen demnach eine bevorzugte Orientierung auf, wobei der Grad der Ausrichtung 83% beträgt. Eine Ausrichtung von mindestens 50% ist gegebenenfalls vorteilhaft.

Die Charakterisierung mittels Röntgendiffraktion von unterschiedlich hergestellten Nanodrähten 34 hat gezeigt, dass die Abscheidebedingungen Einfluss auf die Textur ausüben. Somit kann gezielt die Struktur der Nanodrähte beeinflusst werden.

Die Oberfläche eines Nanodrahtes 34 entspricht nicht der glatten Oberfläche eines Zylinders, auf welcher die Berechnung der geometrischen Oberfläche basiert, sondern zeigt zahlreiche Vertiefungen und Erhöhungen, die die Fläche stark vergrößern. Die tatsächliche Größe der Oberfläche ist also typischerweise größer als die geometrische Oberfläche, unter anderem da die Kristallite, aus denen die Nanodrähte 34 aufgebaut sind, sehr klein sind. Um genauere Vorstellungen von der Oberfläche der Nanodraht-Arrays 35 zu erhalten, wurden cyclovoltammetrische Messungen bei 60°C in 0,5 M $H_2SO_4$ im Potentialbereich von 0 bis 1300 mV bezogen auf eine Normalwasserstoffelektrode durchgeführt. Aus der Ladung, die bei der Adsorption von Wasserstoff übertragen wird, kann unter Berücksichtigung von kapazitiven Strömen die Elektrodenoberfläche berechnet werden. Die cyclovoltammetrischen Untersuchungen von Nanodraht-Array-Elektroden ergaben, dass die tatsächliche Oberfläche um den Faktor 4 bis 5 größer als die geometrische Oberfläche ist.

Anwendungen

Für einen Katalysator ist es möglich, einen Stapel aus einer Vielzahl der erfindungsgemäßen Nanodraht-Strukturelemente 1 zusammen zu schalten. Aufgrund der Abmessungen eignet sich das Nanodraht-Strukturelement 1 aber auch einzeln zum Einbau in mikrostrukturierte Systeme, welche dreidimensionale Strukturen sind, deren innere Abmessungen weniger als 1 mm betragen, meist zwischen zehn und wenigen hundert Mikrometern.

Fig. 10 zeigt schematisch einen Mikrokatalysator 100, in den zwischen einer Fluidzuführung 102 und einer Fluidabführung 104 ein erfindungsgemäßes Nanodraht-Strukturelement 1 eingesetzt ist. Es ist vorstellbar, in solch einem Mikrokatalysator 100 Gas- oder Flüssigphasenreaktionen ablaufen zu lassen. Dazu wird ein Gas- bzw. Flüssigkeitsstrom vorzugsweise mit Druck durch den Mikrokatalysator 100 geleitet.

Das erfindungsgemäß herstellbare Nanodraht-Strukturelement 1 beinhaltet ferner inhärent eine elektrische Kontaktierung aller Nanodrähte. Dadurch kann eine kontrollierte Spannung an die Nanodrähte 34 angelegt werden und somit werden elektrokatalytische Prozesse ermöglicht. Zudem kann das Bauelement als amperometrischer Sensor verwendet werden.

Herstellung von Mikroelementen mit einer Bestrahlungsmaske

Erfindungsgemäß können Nanodraht-Strukturelemente oder Nanodraht-Arrays mit sehr kleinen Abmessungen dadurch erzeugt werden, dass die Templatfolie 12, in diesem Beispiel eine Polymerfolie, durch eine entsprechende Maske mit schweren Ionen bestrahlt wird. Die Maske, z.B. eine Lochmaske, die zuvor aufgebracht wurde, besitzt eine Mehrzahl von Öffnungen oder Bohrungen, wobei jede Öffnung ein späteres Mikroelement definiert. Die Maske deckt bei der Bestrahlung die Templatfolie 12 ab und somit bilden sich latente Ionenspuren 16, die nachfolgend zu Nanoporen 32 aufgeätzt werden, nur in den nicht abgedeckten Bereichen, d.h. an den Öffnungen der Maske. Der Grundriss und die Form der Mikroelemente, wird also durch die Maske vorgegeben.

Dieses Verfahren ist besonders zur Herstellung von vielen, sehr kleinen Nanodraht-Strukturelementen, wie gesagt in Form von Mikroelementen geeignet. Die hiermit herstellbaren Mikroelemente, umfassend ein 2- oder 3-dimensionales Nanodraht-Netzwerk 37, können eine Größe von kleiner als 500 $\mu$m, insbesondere kleiner als 100 $\mu$m und ggf. sogar bis hinunter zu einigen Mikrometern aufweisen.

Zum Beispiel wird eine Lochmaske zur Ionen-Bestrahlung mit etwa 2000 Löchern auf der gesamten Abscheidungsfläche von ungefähr 0,5 cm$^2$ versehen, so dass etwa 2000 Mikroelemente mit Nanodraht-Arrays wie Inseln in der Templatfolie 12 auf einmal erzeugt werden konnten. Nach Entfernung der Kathodenschicht sind die Mikroelemente voneinander getrennt und fallen dann beim Auflösen und Entfernen der Templatfolie auseinander. Es können aber auch noch zusätzliche Schritte vorgesehen sein, z.B. um wiederum Deckschichten für jedes einzelne Mikroelement zu erzeugen.

Da alle Nanodrähte 34 elektrisch kontaktiert sind, eignen sich die Mikroelemente mit Nanodrahtarrays besonders zur Produktion miniaturisierter Sensoren. Aus der großen Anzahl der Drähte sollte sich nicht nur ein hohe Empfindlichkeit, sondern auch eine hohe Defekttoleranz ergeben.

Weitere Anwendung

Insbesondere die Mikroelemente eignen sich zur Herstellung von Sensorelementen, z.B. zum Messen von Gasdurchfluss, Temperatur und als Bewegungssensor. Bezug nehmend auf Fig. 12 weist ein solcher Sensor 150 mindestens eine Messeinheit mit einem ersten und zweiten Nanodraht-Strukturelement 1a auf, wobei die Nanodraht-Strukturelemente 1a jeweils beidseits mit Deckschichten 27 versehen sind, wobei jedes der beiden Nanodraht-Strukturelemente 1a mittels einer oder beiden Deckschichten 27 elektrisch kontaktiert wird, wobei die beiden Nanodraht-Strukturelemente 1a separat kontaktiert werden. Zwischen den beiden Nanodraht-Strukturelementen ist ein Heizelement, z.B. ein durch Anlegen einer Spannung heizbarer Mikrodraht 152, angeordnet. Die Änderung des Widerstandes des Sensorelementes 150 wird als Maß für den Gasdurchfluss oder die Temperaturänderung oder eine Bewegungsänderung verwendet.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne die Erfindung zu verlassen. Insbesondere ist die Herstellung eines Mikrokatalysators nur eines von vielen Anwendungsgebieten für das erfindungsgemäße Nanodraht-Strukturelement. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind.

**Patentansprüche**

1.  Verfahren zur Herstellung eines Nanodraht-Strukturelements (1), umfassend die folgenden Schritte:

    (a) Bereitstellen eines Templats (12),
    (b) Bestrahlen des Templats (12) mit energetischer Strahlung (14) unter zumindest drei unterschiedlichen Winkeln bezogen auf die Oberfläche des Templats, das heißt aus zumindest drei unterschiedlichen Richtungen, wobei die drei Richtungen nicht in einer gemeinsamen Ebene liegen, zur Erzeugung einer Vielzahl, das Templat durchsetzender latenter Spuren (16),
    (c) Ätzen des Templats (12), um die strahlungsinduzierten latenten Spuren (16) zu einem Netzwerk (33) aus gekreuzt miteinander verbundenen Nanoporen (32) aufzuätzen,
    (d) Abscheiden von Material in den Nanoporen (32) zum Erzeugen eines Netzwerks (37) aus gekreuzt miteinander verbundenen Nanodrähten (34) in dem Nanoporen-Netzwerk (33), so dass das erzeugte Nanodraht-Netzwerk (37) das Templat durchsetzt, wobei die Nanodrähte einen Durchmesser von kleiner oder gleich 2000 nm aufweisen,
    (e) Auflösen und Entfernen des Templats (12) aus dem entstandenen Nanodraht-Netzwerk (37).

2.  Verfahren nach Anspruch 1, wobei vor dem Schritt (d) eine elektrisch leitfähige Kathodenschicht (26a) auf einer ersten Seite (12a) des Templats (12) aufgebracht wird und in dem Schritt (d) das Nanodraht-Netzwerk (37) in dem Nanoporen-Netzwerk (33) mittels elektrochemischer Abscheidung auf der Kathodenschicht (26a) aufwächst.

3.  Verfahren nach einem der vorstehenden Ansprüche, wobei die Templatfolie durch eine Maske mit einer oder mehreren Öffnungen bestrahlt wird, so dass die latenten Spuren (16) nur im Bereich der Öffnungen der Maske erzeugt werden.

4.  Verfahren nach einem der vorstehenden Ansprüche, wobei das entstandene Nanodraht-Netzwerk ein selbsttragendes Nanodraht-Strukturelement bildet.

5.  Nanodraht-Strukturelement (1), herstellbar gemäß einem der vorstehenden Ansprüche, umfassend ein Array (35) aus einer Vielzahl von Nanodrähten (34),

    - wobei die Nanodrähte einen Durchmesser von kleiner oder gleich 2000 nm aufweisen,
    - wobei die Nanodrähte (34) in unterschiedlichen Richtungen verlaufen und sich die Nanodrähte (34) an einer Vielzahl von Knotenpunkten (39) kreuzen,
    - wobei die Nanodrähte (34) an den Knotenpunkten (39) miteinander verwachsen sind, so dass die Nanodrähte (34) zu einem Netzwerk (37) vernetzt sind,
    - wobei die Nanodrähte (34) in dem Netzwerk (37) entlang zumindest drei vordefinierten unterschiedlichen Richtungen verlaufen, und
    - wobei die drei unterschiedlichen Richtungen nicht in einer gemeinsamen Ebene liegen, und
    - die Nanodrähte (34) dreidimensional vernetzt sind.

6.  Nanodraht-Strukturelement (1) nach Anspruch 5, wobei das Nanodraht-Netzwerk (37) aus elektrochemisch abgeschiedenen Nanodrähten besteht.

7.  Nanodraht-Strukturelement (1) nach Anspruch 5 oder 6, wobei das Nanodraht-Strukturelement zumindest eine Flachseite aufweist und welches zumindest auf dieser Flachseite des Nanodraht-Strukturelements keine Deckschicht aufweist und das Nanodraht-Netzwerk (37) auf zumindest dieser einen Flachseite offen ist.

8.  Nanodraht-Strukturelement (1) nach einem der Ansprüche 5 bis 7, ferner umfassend eine Substratschicht (27) mit der das Nanodraht-Netzwerk (37) fest verbunden ist.

9.  Nanodraht-Strukturelement (1) nach einem der Ansprüche 5 bis 8, wobei die Nanodrähte (34) eine kristallitische Textur oder eine einkristalline Struktur aufweisen.

10. Nanodraht-Strukturelement (1) nach einem der Ansprüche 5 bis 9, wobei das Nanodraht-Strukturelement ein selbsttragendes Nanodraht-Strukturelement ist.

11. Nanodraht-Strukturelement (1) nach einem der Ansprüche 5 bis 10, wobei die Nanodrähte zumindest entlang von drei nicht parallelen Achsen verlaufen, die zumindest zwei Ebenen aufspannen, die wiederum nicht parallel sind.

12. Mikroreaktorsystem, umfassend:

ein mikrostrukturiertes Kanalsystem mit einer Fluidzuführung und einer Fluidabführung, zumindest ein Nanodraht-Strukturelement (1) gemäß einem der Ansprüche 5 bis 11 als Reaktorelement zwischen der Fluidzuführung und der Fluidabführung, derart dass Fluid aus der Fluidzuführung durch die Zwischenräume in dem Nanodraht-Netzwerk (37) hindurch geleitet und durch die Fluidabführung wieder aus dem Nanodraht-Netzwerk abgeführt werden kann, wobei die offenzellige Hohlraumstruktur des Nanodraht-Netzwerks (37) das Reaktionsvolumen bildet und die Zylinderflächen der Nanodrähte (34) zumindest einen Teil der aktiven Oberfläche bilden, mit der das Fluid innerhalb der Hohlraumstruktur während des Durchfließens wechselwirkt.

13. Katalysatorsystem, umfassend:

ein Kanalsystem mit einer Fluidzuführung und einer Fluidabführung, zumindest ein Nanodraht-Strukturelement (1) gemäß einem der Ansprüche 5 bis 11 als Katalysatorelement zwischen der Fluidzuführung und der Fluidabführung, derart dass Fluid aus der Fluidzuführung durch die Zwischenräume in dem Nanodraht-Netzwerk (37) hindurch geleitet und durch die Fluidabführung wieder aus dem Nanodraht-Netzwerk abgeführt werden kann, wobei die offenzellige Hohlraumstruktur des Nanodraht-Netzwerks (37) das katalytische Reaktionsvolumen bildet und die Zylinderflächen der Nanodrähte (34) zumindest einen Teil der katalytisch aktiven Oberfläche bilden, mit der das Fluid innerhalb der Hohlraumstruktur während des Durchfließens wechselwirkt.

14. Sensorelement (150), aufweisend: mindestens eine Messeinheit mit einem ersten Nanodraht-Strukturelement und einem zweiten Nanodraht-Strukturelement (1, la) jeweils gemäß einem der Ansprüche 5 bis 11, wobei die Nanodraht-Strukturelemente jeweils zumindest eine mit den Nanodrähten (34) verbundene Substratschicht (27) zum Kontaktieren des jeweiligen Nanodraht-Strukturelements aufweisen und wobei zwischen den Nanodraht-Strukturelementen ein Heizelement (152) angeordnet ist.

**Claims**

1. A method for producing a nanowire structural element (1), comprising the steps of:

(a) providing a template (12);
(b) irradiating the template (12) with energetic radiation (14) under at least three different angles with respect to the surface of the template, that is from at least three different directions, wherein said three directions do not lie in a common plane, to generate a multitude of latent traces (16) permeating the template;
(c) etching the template (12) so as to widen by the etching the radiation-induced latent traces (16) to form a network (33) of intersecting interconnected nanopores (32);
(d) depositing material in said nanopores (32) to form a network (37) of intersecting interconnected nanowires (34) within the nanopore network (33), so that the produced nanowire network (37) permeates the template, the nanowires having a diameter of less than or equal to 2000 nm;
(e) dissolving and removing the template (12) from the resulting nanowire network (37).

2. The method according to claim 1, wherein prior to step (d), an electrically conductive cathode layer (26a) is deposited to a first side (12a) of the template (12), and in step (d) the nanowire network (37) grows in the nanopore network (33) on the cathode layer (26a) by electrochemical deposition.

3. The method according to any one of the preceding claims, wherein the template film is irradiated through a mask having one or more openings, so that the latent tracks (16) are generated only in the area of the openings of the mask.

4. The method according to any one of the preceding claims, wherein the resulting nanowire network forms a self-supporting nanowire structural element.

5. A nanowire structural element (1), producible according to any one of the preceding claims, comprising an array (35) of a multitude of nanowires (34);

- wherein the nanowires have a diameter of less than or equal to 2000 nm;
- wherein the nanowires (34) extend in different directions and the nanowires (34) intersect at a multitude of nodes (39);
- wherein the nanowires (34) are grown together at the nodes (39) so that the nanowires (34) are interlinked to form a network (37);
- wherein the nanowires (34) in the network (37) extend along at least three predefined different directions; and
- wherein the three different directions do not lie in a common plane; and
- the nanowires (34) are three-dimensionally interlinked.

6. The nanowire structural element (1) according to claim 5, wherein the nanowire network (37) consists of electrochemically deposited nanowires.

7. The nanowire structural element (1) according to claim 5 or 6,
wherein the nanowire structural element has at least one planar side and has no cover layer at least on this planar side of the nanowire structural element, and wherein the nanowire network (37) is open on at least this one planar side.

8. The nanowire structural element (1) according to any one of claims 5 to 7, further comprising a substrate layer (27) to which the nanowire network (37) is firmly connected.

9. The nanowire structural element (1) according to any one of claims 5 to 8, wherein the nanowires (34) have a crystallite texture or a monocrystalline structure.

10. The nanowire structural element (1) according to any one of claims 5 to 9, wherein the nanowire structural element is a self-supporting nanowire structural element.

11. The nanowire structural element (1) according to any one of claims 5 to 10, wherein the nanowires extend along at least three non-parallel axes that span at least two planes which in turn are not parallel.

12. A microreactor system, comprising:

a microstructured channel system having a fluid inlet and a fluid outlet;
at least one nanowire structural element (1) according to any one of claims 5 to 11 as a reactor element between the fluid inlet and the fluid outlet,
such that fluid from the fluid inlet can pass through the open spaces in the nanowire network (37) and can be discharged from the nanowire network through the fluid outlet;
wherein the open-cell cavity structure of the nanowire network (37) defines the reaction volume and the cylindrical surfaces of the nanowires (34) provide at least part of the active surface area with which the fluid interacts within the cavity structure while flowing therethrough.

13. A catalyst system, comprising:

a channel system having a fluid inlet and a fluid outlet;
at least one nanowire structural element (1) according to any one of claims 5 to 11 as a catalyst element between the fluid inlet and the fluid outlet;
such that fluid from the fluid inlet can pass through the open spaces in the nanowire network (37) and can be discharged from the nanowire network through the fluid outlet;
wherein the open-cell cavity structure of the nanowire network (37) defines the catalytic reaction volume and the cylindrical surfaces of the nanowires (34) provide at least part of the catalytically active surface area with which the fluid interacts within the cavity structure while flowing therethrough.

14. A sensor element (150), comprising:
at least one measurement unit including a first nanowire structural element and a second nanowire structural element (1, 1a), each one according to any one of claims 5 to 11, each of the nanowire structural elements having at least one substrate layer (27) connected to the nanowires (34) for electrically connecting the respective nanowire structural element, and with a heating element (152) arranged between the nanowire structural elements.

**Revendications**

1. Procédé de fabrication d'un élément structurel à nanofils (1), comprenant les étapes suivantes :

(a) mise à disposition d'une matrice (12),
(b) irradiation de la matrice (12) avec un rayonnement énergétique (14), sous au moins trois angles différents par rapport à la surface de la matrice, c'est-à-dire depuis au moins trois directions différentes, les trois directions ne se situant pas dans un même plan, en vue de générer une pluralité de traces latentes (16) traversant la matrice,
(c) gravure de la matrice (12) pour obtenir par gravure que les traces latentes (16) induites par rayonnement forment un réseau (33) de nanopores (32) reliés entre eux de manière croisée, (d) séparation de matériau dans les nanopores (32) pour créer un réseau (37) de nanofils (34) reliés entre eux de manière croisée dans le réseau de nanopores (33), de telle sorte que le réseau de nanofils (37) réalisé traverse la matrice, les nanofils présentant un diamètre inférieur ou égal à 2 000 nm, (e) dissolution et retrait de la matrice (12) du réseau de nanofils (37) créé.

2. Procédé selon la revendication 1, selon lequel une couche cathodique (26a) électriquement conductrice est appliquée sur une première face (12a) de la matrice (12) avant l'étape (d) et, au cours de l'étape (d), le réseau de nanofils (37) se forme par croissance dans le réseau de nanopores (33), par séparation électrochimique sur la couche cathodique (26a).

3. Procédé selon l'une des revendications précédentes, selon lequel le film de matrice est irradié à travers un masque comportant une ou plusieurs ouvertures, de sorte que les traces latentes (16) soient générées uniquement dans la région des ouvertures du masque.

4. Procédé selon l'une des revendications précédentes, selon lequel le réseau de nanofils obtenu constitue un élément structurel à nanofils autoportant.

5. Élément structurel à nanofils (1) pouvant être fabriqué selon l'une des revendications précédentes, comprenant un réseau (35) formé d'une pluralité de nanofils (34),

 - dans lequel les nanofils présentent un diamètre inférieur ou égal à 2 000 nm,
 - dans lequel les nanofils (34) s'étendent dans des directions différentes, et les nanofils (34) se croisent dans une pluralité de nœuds (39),
 - dans lequel les nanofils (34) sont enchevêtrés entre eux dans les noeuds (39), de sorte que les nanofils (34) sont entrelacés pour former un réseau (37),
 - dans lequel les nanofils (34) s'étendent dans le réseau (37) le long d'au moins trois directions différentes prédéfinies, et
 - dans lequel les trois directions différentes ne se situent pas dans un même plan, et
 - les nanofils (34) sont entrelacés sous une forme tridimensionnelle.

6. Élément structurel à nanofils (1) selon la revendication 5, dans lequel le réseau de nanofils (37) est constitué de nanofils séparés par voie électrochimique.

7. Élément structurel à nanofils (1) selon la revendication 5 ou 6, dans lequel l'élément structurel à nanofils présente au moins un côté plat, et qui ne présente pas de couche de revêtement, au moins sur ce côté plat de l'élément structurel à nanofils, et dans lequel le réseau de nanofils (37) est ouvert au moins sur ce côté plat.

8. Élément structurel à nanofils (1) selon l'une des revendications 5 à 7, comprenant en outre une couche de substrat (27) à laquelle est lié solidement le réseau de nanofils (37).

9. Élément structurel à nanofils (1) selon l'une des revendications 5 à 8, dans lequel les nanofils (34) présentent une texture de cristallite ou une structure monocristailine.

10. Élément structurel à nanofils (1) selon l'une des revendications 5 à 9, dans lequel l'élément structure! à nanofils est un élément structurel à nanofils autoportant.

11. Élément structurel à nanofils (1) selon l'une des revendications 5 à 10, dans lequel les nanofils s'étendent le long d'au moins trois axes non parallèles qui définissent au moins deux plans qui ne sont à leur tour pas parallèles.

12. Système de microréacteur, comprenant :

 un système de canaux à microstructure, doté d'une alimentation en fluide et d'une évacuation de fluide,
 au moins un élément structurel à nanofils (1) selon l'une des revendications 5 à 11, en tant qu'élément réacteur entre l'alimentation en fluide et l'évacuation de fluide,
 de telle sorte que le fluide puisse être dirigé depuis l'alimentation en fluide, à travers les interstices dans le réseau de nanofils (37), et être évacué de nouveau du réseau de nanofils, à travers l'évacuation de fluide,
 sachant que la structure de cavités à cellules ouvertes du réseau de nanofils (34) constitue le volume de réaction, et que les surfaces cylindriques des nanofils (34) forment au moins une partie de la surface active avec laquelle le fluide est en interaction pendant l'écoulement à l'intérieur de la structure à cavités.

13. Système de catalyseur, comprenant :

 un système de canaux doté d'une alimentation en fluide et d'une évacuation de fluide,
 au moins un élément structurel à nanofils (1) selon l'une des revendications 5 à 11, en tant qu'élément catalyseur entre l'alimentation en fluide et l'évacuation de fluide,

de telle sorte que le fluide puisse être dirigé depuis l'alimentation en fluide, à travers les interstices dans le réseau de nanofils (37), et évacué de nouveau du réseau de nanofils, à travers l'évacuation de fluide,

sachant que la structure de cavités à cellules ouvertes du réseau de nanofils (34) constitue le volume de réaction catalytique, et que les surfaces cylindriques des nanofils (34) forment au moins une partie de la surface active sur le plan catalytique, avec laquelle le fluide est en interaction pendant l'écoulement à l'intérieur de la structure à cavités.

**14.** Élément capteur (150), présentant :

au moins une unité de mesure avec un premier élément structurel à nanofils et un deuxième élément structure! à nanofils (1, 1a), respectivement selon l'une des revendications 5 à 11, les éléments structurels à nanofils présentant chacun au moins une couche de substrat (27) liée aux nanofils (34), aux fins de connexion de l'élément structurel à nanofils concerné, et un élément chauffant (152) étant disposé entre les éléments structurels à nanofils.

# Fig. 1

Fig. 2

Fig. 3

Fig. 4

Fig. 5

34

37

34

Fig. 6

39

34

37

34

200 nm

39

# Fig. 7

(a)

**12**

Polycarbonat-Templatfolie

(b) Bestrahlung

(c) Ätzen

(c)

**12b**

**32**

**33**

**12**

**12a**

3-D Nanoporen-Netzwerk

Elektrochemische Abscheidung

(e)

**39**

**34**

**37**

**39**

**34**

**27**

**1**

Freistehendes
3D-Nanodraht-Netzwerk

(b1),(b2),(d)

Templatentfernung

**34**

**37**

**12**

**26a**

3-D Nanodraht-Array
in Polymermatrix

Fig. 8

Fig. 9

Fig. 10

MFR      SE  LM   SEI   10.0kV   X65   WD 5.6mm   100μm

Fig. 11

Fig. 12

Gasfluss

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **K. JÄHNISCH et al.** Chemistry in Microstructured Reactors. *Ang. Chem. Int. Ed.,* 2004, vol. 43, 406-446
- **O. WÖRZ et al.** Microreactors - a New Efficient Tool for Reactor Development. *Chem. Eng. Technol.,* 2001, vol. 24, 138-142
- **M. FICHTNER.** Microstructured Rhodium Catalysts for the Partial Oxidation of Methane to Syngas under Pressure. *Ind. Eng. Chem. Res.,* 2001, vol. 40, 3475-3483
- **G. VESER.** Experimental and Theoretical Investigation of H2 Oxidation in a High-Temperature Catalytic Microreactor. *Chem. Eng. Sci.,* 2001, vol. 56, 1265-1273
- **R. NARAYANAN et al.** Catalysis with Transition Metal Nanoparticles in Colloidal Solution: Nanoparticle Shape Dependence and Stability. *J. Chem. Phys. B,* 2005, vol. 109, 12663-12676
- **Z. CHEN et al.** Supportless Pt and PtPd Nanotubes as Electrocatalysts for Oxygen-Reduction Reactions. *Angew. Chem.,* 2007, vol. 119, 4138-4141
- **J. H. YUAN et al.** Highly ordered Platinum-Nanotubule Arrays for Amperometric Glucose Sensing. *Adv. Funct. Mater,* 2005, vol. 15, 803
- **H. WANG et al.** Pd nanowire arrays as electrocatalysts for ethanol electrooxidation. *Electrochem. Commun.,* 2007, vol. 9, 1212-1216
- **H. M. ZHANG et al.** novel .electrocatalytic activity in layered Ni-Cu nanowire arrays. *Chem. Commun.,* 2003, 3022
- **NIELSCH et al.** Uniform Nickel Deposition into ordered Alumina pores by pulsed electrodeposition. *Adv. Mater.,* 2000, vol. 12, 582-586
- **T. W. CORNELIUS et al.** Controlled fabrication of poly- and single-crystalline bismuth nanowires. *Nanotechnology,* 2005, vol. 16, 246-249
- **LINDBERG et al.** Interconnected nanowire clusters in polyimide for flexible circuits and magnetic sensing applications. *Sensors and Actuators A,* 2003, vol. 105, 150-161